# EUROPEAN PATENT APPLICATION

(11) **EP 4 848 342 A1**
(43) Date of publication of application: **02.12.2026**
(21) Application number: 24923476.6
(22) Date of filing: 27.11.2024
(51) Int. Cl.: H01L 25/16, H10H 20/821

(54) **PHOTOELECTRIC DEVICE, LIGHT-EMITTING MODULE, AND ELECTRONIC DEVICE**

(30) Priority: 08.02.2024 CN 202410178180
(71) Applicant: Huawei Technologies Co., Ltd., Shenzhen, Guangdong 518129 (CN)
(72) Inventor: SU, Xilin, Shenzhen, Guangdong 518129 (CN); XIAO, Junyi, Shenzhen, Guangdong 518129 (CN); WU, Dihai, Shenzhen, Guangdong 518129 (CN); ZHENG, Xianchao, Shenzhen, Guangdong 518129 (CN); WEI, Chaogang, Shenzhen, Guangdong 518129 (CN); CUI, Hao, Shenzhen, Guangdong 518129 (CN)
(74) Representative: Huawei European IPR
(86) International application number: PCT/CN2024/135039
(87) International publication number: WO 2025/167274

(57) **Abstract**

This application discloses a photoelectric device, a light-emitting module, and an electronic device. The photoelectric device (10) includes a plurality of light-emitting pixels (200), a groove region (400), and an electrode metal layer (230). The electrode metal layer (230) is configured to electrically connect to a second electrode. The groove region includes a first groove part (401) and a second groove part (402). The electrode metal layer (230) covers at least a partial surface of each light-emitting pixel (200), at least a partial region of the first groove part (401), and at least a partial region of the second groove part (402). A wire width of the electrode metal layer (230) is not limited by a size of the first groove part (401), so that the electrode metal layer (230) meets a current extension requirement, to improve current uniformity of the light-emitting pixel. In addition, the electrode metal layer (230) is insulated from the semiconductor functional layer (210) in the first groove part (401), without reserving a large region in the first groove part (401). This can greatly reduce occupation of an active light-emitting region in the light-emitting pixel (200) by the first groove part (401), and increase an area of the active light-emitting region.

## Description

### CROSS-REFERENCE TO RELATED APPLICATIONS

This application claims priority to Chinese Patent Application No. 202410178180.6, filed with the China National Intellectual Property Administration on February 8, 2024 and entitled "PHOTOELECTRIC DEVICE, LIGHT-EMITTING MODULE, PREPARATION METHOD, AND ELECTRONIC DEVICE", which is incorporated herein by reference in its entirety.

### TECHNICAL FIELD

This application relates to the field of light-emitting technologies, and in particular, to a photoelectric device, a light-emitting module, and an electronic device.

### BACKGROUND

A light-emitting diode (Light-Emitting Diode, LED) has advantages such as a long service life, high luminance, and low power consumption, and may be widely used in the display field, the lighting field, the projection field, and the like. Usually, a plurality of LEDs may be disposed together to form a photoelectric device, and electrodes of the LEDs in the photoelectric device are correspondingly connected to weld legs on a drive device, to drive, through the drive device, the LEDs to emit light.

### SUMMARY

Embodiments of this application provide a photoelectric device, a light-emitting module, and an electronic device, to form a photoelectric device with high-density light-emitting pixels.

According to a first aspect, an embodiment of this application provides a photoelectric device. The photoelectric device includes a plurality of light-emitting pixels, a groove region, and an electrode metal layer. Each light-emitting pixel includes a semiconductor functional layer and a first electrode. Each semiconductor functional layer includes a first semiconductor layer. The plurality of light-emitting pixels share a first semiconductor layer. The groove region is formed on the semiconductor functional layer. The groove region is located between the plurality of light-emitting pixels. The electrode metal layer is configured to electrically connect to a second electrode. In addition, the groove region includes a first groove part and a second groove part, and the electrode metal layer covers at least a partial surface of each light-emitting pixel, at least a partial region of the first groove part, and at least a partial region of the second groove part. The electrode metal layer is insulated from the semiconductor functional layer in the first groove part, and the electrode metal layer is electrically connected to the first semiconductor layer in the second groove part.

In the conventional technology, a second electrode is usually a metal mesh wire, and therefore a width of a groove region needs to be large. In this embodiment of this application, the electrode metal layer connected to the second electrode is disposed, and the electrode metal layer is electrically connected to the first semiconductor layer in the second groove part. In this way, a voltage in the second electrode can be input to a first semiconductor layer in each light-emitting pixel through the electrode metal layer, to supply power to the first semiconductor layer in each light-emitting pixel, so that a quantity of interconnection points is reduced. In addition, the electrode metal layer not only covers at least a partial region of the first groove part, but also covers at least a partial surface of each light-emitting pixel and at least a partial region of the second groove part, so that a wire width of the electrode metal layer is not limited by a size of the first groove part, and a conductive area of the electrode metal layer can be increased, to reduce a voltage drop of the electrode metal layer. In this way, the electrode metal layer can withstand a larger current, and the electrode metal layer meets a current extension requirement, to improve current uniformity of the light-emitting pixel. In addition, the electrode metal layer is insulated from the semiconductor functional layer in the first groove part. To be specific, an electrode metal layer in the first groove part does not need to be in contact with the first semiconductor layer. Therefore, no large region needs to be reserved in the first groove part, provided that the first groove part can implement isolation between light-emitting pixels. In this way, a width of the first groove part can be reduced, to greatly reduce occupation of an active light-emitting region in the light-emitting pixel by the first groove part, and increase an area of the active light-emitting region.

In addition, usually, a metal layer has strong light absorption. If a large area of the metal layer is in contact with the first semiconductor layer, light is absorbed by the metal layer through the first semiconductor layer, leading to a decrease in light-emitting efficiency of the device. In this embodiment of this application, the electrode metal layer is insulated from the semiconductor functional layer in the first groove part, and the electrode metal layer is in contact with the first semiconductor layer in the second groove part to implement an electrical connection. Compared with the conventional technology in which all electrode metal layers in a groove region need to be in contact with a first semiconductor layer, in this embodiment of this application, a proportion of an area, in direct contact with the first semiconductor layer, of the electrode metal layer can be reduced, to reduce light absorption of the electrode metal layer, and improve light-emitting efficiency of the device.

In some embodiments, a first dimension exists between side walls of a groove region having the second groove part, a second dimension exists between side walls of a groove region having the first groove part, and a maximum value of the first dimension is greater than a maximum value of the second dimension. In this way, the size of the first groove part in the groove region can be reduced, and specific space is reserved in the groove region for the second groove part, to increase an area of electrical connection between the electrode metal layer and the first semiconductor layer, and improve reliability of power supply.

In some embodiments, the first groove part is located between adjacent light-emitting pixels, and the first groove part further surrounds the second groove part and is in communication with the second groove part. In this way, the electrode metal layer can extend in the first groove part and the second groove part.

In some embodiments, the groove region is of a grid pattern, and the second groove part is arranged in at least a part of grid cross regions in the grid pattern. In this way, the second groove part is arranged in the grid cross region, and therefore all grid lines may be arranged as the first groove part. In this case, a width of the first groove part arranged on the grid lines can be reduced, to increase an area of the active light-emitting region.

In some embodiments, the groove region is of a grid pattern, and the second groove part is arranged on at least a part of grid lines in the grid pattern.

In some embodiments, a proportion of the first groove part in the groove region is greater than or equal to 50%, and the proportion of the first groove part in the groove region is less than 100%.

In some embodiments, a proportion of the second groove part in the groove region is greater than 0, and the proportion of the second groove part in the groove region is less than or equal to 50%.

In some embodiments, the electrode metal layer covers at least a partial region of a bottom wall of the first groove part. For example, the electrode metal layer covers all regions of the bottom wall of the first groove part, to maximize an area of the electrode metal layer, and improve current uniformity.

In some embodiments, the electrode metal layer covers at least a partial region of a bottom wall of the second groove part. For example, the electrode metal layer covers all regions of the bottom wall of the second groove part, to maximize an area of the electrode metal layer, and improve current uniformity.

In some embodiments, a part, extending from the first groove part to the second groove part, of the electrode metal layer forms a step shape, to reduce a risk of fracture of the electrode metal layer, and improve reliability.

In some embodiments, a first dielectric layer is disposed between the electrode metal layer and the bottom wall of the first groove part. In this way, the electrode metal layer is insulated from the bottom wall of the first groove part through the first dielectric layer. In addition, the first dielectric layer is reused to raise the electrode metal layer, so that the electrode metal layer can extend along the first dielectric layer to the bottom wall of the second groove part, and the part, extending from the first groove part to the second groove part, of the electrode metal layer can form the step shape.

In some embodiments, a region, corresponding to the light-emitting pixel, of the first semiconductor layer is protrudingly arranged, and a region between first semiconductor layers of adjacent light-emitting pixels is concave to form the groove region. In addition, a first semiconductor layer between adjacent light-emitting pixels forms a bottom wall of the groove region, and a side wall of the protruding region of the first semiconductor layer forms at least a partial side wall of the groove region. In this way, first semiconductor layers that are disposed in a protruding manner and that are located in different light-emitting pixels can be separated by the groove region. To be specific, a groove is formed in the shared first semiconductor layer as a part of the groove region.

In some embodiments, the semiconductor functional layer further includes a light-emitting layer and a second semiconductor layer, the light-emitting layer is disposed on the first semiconductor layer that is disposed in a protruding manner, the second semiconductor layer is disposed on the light-emitting layer, and the first electrode is electrically connected to the second semiconductor layer. In addition, the side wall of the protruding region of the first semiconductor layer, a side wall of the light-emitting layer, and a side wall of the second semiconductor layer form a side wall of the groove region. That is, light-emitting layers and second semiconductor layers of adjacent pixels are completely isolated by a groove. In this way, light-emitting layers and second semiconductor layers in different light-emitting pixels can be separated by the groove region.

In some embodiments, the electrode metal layer covers the side wall of the first semiconductor layer, the side wall of the light-emitting layer, and the side wall of the second semiconductor layer, and a second dielectric layer is disposed between the electrode metal layer and the side wall of the first semiconductor layer, the side wall of the light-emitting layer, and the side wall of the second semiconductor layer. In this way, an area of the electrode metal layer is further increased, to improve current uniformity.

In some embodiments, the light-emitting pixel further includes a current extension layer, the current extension layer is disposed on the second semiconductor layer, the second dielectric layer further covers a side wall of the current extension layer, and the electrode metal layer further covers a second dielectric layer on the side wall of the current extension layer. In this way, an area of the electrode metal layer is further increased, to improve current uniformity.

In some embodiments, a surface, facing away from the second semiconductor layer, of the current extension layer is a first surface, the electrode metal layer extends to cover the first surface and forms a second contact hole on the first surface in an enclosed manner, and the second dielectric layer extends to cover the first surface and forms a third contact hole on an inner side of the second contact hole in an enclosed manner. In addition, the first electrode is electrically connected to the second semiconductor layer through the second contact hole and the third contact hole, and the first electrode is insulated from the electrode metal layer.

In some embodiments, a part, extending from the side wall of the second semiconductor layer to the first surface, of the electrode metal layer forms a double-step shape, to reduce a risk of fracture of the electrode metal layer, and improve reliability.

In some embodiments, a surface, facing away from the light-emitting layer, of the second semiconductor layer has a first region and a second region, the first region surrounds the second region, and the current extension layer covers the second region. In addition, the second dielectric layer further covers the first region, and the electrode metal layer further covers a second dielectric layer located in the first region. In this way, the part, extending along the side wall of the second semiconductor layer to the first surface, of the electrode metal layer can form a step shape. In addition, an area of the electrode metal layer can be further increased, to improve current uniformity.

In some embodiments, the first electrode includes a first electrode connection layer and a first electrode pad layer that are connected to each other, the first electrode connection layer is disposed between the first electrode pad layer and the current extension layer, and the first electrode connection layer is connected to the current extension layer through the second contact hole and the third contact hole.

In some embodiments, in a stacking direction of the light-emitting layer and the second semiconductor layer, a spacing between an outer boundary of the first electrode connection layer and an outer boundary of the second contact hole is greater than 0. In the stacking direction of the light-emitting layer and the second semiconductor layer, the first electrode connection layer covers the second contact hole; or in the stacking direction of the light-emitting layer and the second semiconductor layer, the first electrode connection layer is disposed in the second contact hole.

In some embodiments, in the stacking direction of the light-emitting layer and the second semiconductor layer, the first electrode pad layer covers the second contact hole, and a passivation layer is disposed between the first electrode pad layer and the electrode metal layer, to implement insulation.

In some embodiments, a profile of the first electrode connection layer in the stacking direction of the light-emitting layer and the second semiconductor layer has a first groove, and the first groove is filled with a partial region of the first electrode pad layer. In this way, the partial region of the first electrode pad layer is embedded in the first groove to form a step-shaped pad, to improve reliability.

In some embodiments, the photoelectric device further includes one or more boss structures, the boss structure has a second surface, and the second electrode is disposed on the second surface. In this way, the second electrode is raised by using the boss structure, and when the first electrode and the second electrode are separately connected to a drive device through interconnection structures, a length difference between an interconnection structure connected to the first electrode and an interconnection structure connected to the second electrode can be minimized, to reduce a risk of a device failure, and improve reliability of interconnection between the photoelectric device and the drive device.

In some embodiments, the groove region is further arranged between the boss structure and the light-emitting pixel. For example, the groove structure arranged between the boss structure and the light-emitting pixel may include only the first groove part or the second groove part, or may include both the first groove part and the second groove part. In this way, an area of the electrode metal layer can be further increased, to improve current uniformity of the light-emitting pixel.

In some embodiments, when a plurality of boss structures are disposed, the groove region is further arranged between boss structures. For example, the groove structure arranged between the boss structures may include only the first groove part or the second groove part, or may include both the first groove part and the second groove part. In this way, an area of the electrode metal layer can be further increased, to improve current uniformity of the light-emitting pixel.

In some embodiments, the electrode metal layer further covers a side wall of the boss structure. In this way, an area of the electrode metal layer can be further increased, to improve current uniformity of the light-emitting pixel.

In some embodiments, the second electrode includes a second electrode connection layer and a second electrode pad layer that are connected to each other, and the second electrode connection layer is disposed between the second electrode pad layer and the boss structure. In addition, the second electrode connection layer covers at least a partial region of the second surface, and the electrode metal layer and the second electrode connection layer are connected to each other. In this way, an area of the second electrode connection layer is further increased, to improve current uniformity.

In some embodiments, a third dielectric layer is disposed between the second electrode connection layer and the boss structure, and the third dielectric layer covers the side wall of the boss structure. In addition, the third dielectric layer further extends to the second surface and forms a fourth contact hole on the second surface in an enclosed manner, and the second electrode connection layer covers the third dielectric layer and is in contact with the second surface through the fourth contact hole; or the third dielectric layer covers the second surface, and the second electrode connection layer covers the third dielectric layer. In this way, a second electrode connection layer located on the second surface and a first electrode connection layer located on the first surface can be disposed to be of a same structure if possible.

In some embodiments, the boss structure is of a single-layer structure, and the boss structure includes one of a semiconductor material layer, an insulation material layer, or a metal material layer.

In some embodiments, the boss structure is of a multi-layer structure, and the boss structure includes a combination of a semiconductor material layer, an insulation material layer, or a metal material layer.

In some embodiments, the boss structure is of a multi-layer structure, and the boss structure includes the semiconductor functional layer. In this way, the boss structure can also be formed when the semiconductor functional layer is formed. This not only can minimize a difference between the boss structure and the semiconductor functional layer, but also can simplify preparation operations of a process.

In some embodiments, the boss structure is of a multi-layer structure, and the boss structure includes the semiconductor functional layer and the current extension layer disposed on the semiconductor functional layer. In this way, the boss structure can also be formed when the semiconductor functional layer and the current extension layer are formed. This not only can minimize differences between the boss structure and the semiconductor functional layer and between the boss structure and the current extension layer, but also can simplify preparation operations of a process.

In some embodiments, the light-emitting pixel further includes a distributed Bragg reflection layer, and the distributed Bragg reflection layer is disposed between the electrode metal layer and the second dielectric layer. In this way, reflection efficiency can be improved.

According to a second aspect, an embodiment of this application further provides a photoelectric device. The photoelectric device includes a plurality of light-emitting pixels, a groove region, and a first reflection layer. Each light-emitting pixel includes a semiconductor functional layer and a first electrode. Each semiconductor functional layer includes a first semiconductor layer that is disposed in a stacked manner. In addition, the first reflection layer covers at least a partial region of each light-emitting pixel, and further covers at least a partial region of the groove region. In addition, the first electrode is insulated from the first reflection layer, so that the first electrode inputs a first voltage to a second semiconductor layer. In this way, the first reflection layer reflects, to a light exit surface as much as possible, light transmitted by the semiconductor functional layer toward a side wall of the first reflection layer and the first electrode, to improve light output efficiency of the device.

In addition, for other structures of the photoelectric device in embodiments of the second aspect, refer to descriptions of related structures in the embodiments of the first aspect. Details are not described herein again. It should be noted that implementations of the embodiments of the second aspect may alternatively not rely on the implementations of the first aspect, and may alternatively be other implementations. This is not specifically limited herein.

According to a third aspect, an embodiment of this application further provides a photoelectric device. The photoelectric device includes a plurality of light-emitting pixels, a groove region, and an electrode metal layer. Each light-emitting pixel includes a semiconductor functional layer and a first electrode. Each semiconductor functional layer includes a first semiconductor layer, a light-emitting layer, and a second semiconductor layer that are disposed in a stacked manner. The second semiconductor layer is electrically connected to the first electrode. The electrode metal layer is electrically connected to a second electrode. In addition, the groove region is formed on the semiconductor functional layer, and the groove region may be used to isolate the plurality of light-emitting pixels from each other. The groove region may include a first groove part and a second groove part, and the electrode metal layer covers at least a partial surface of each light-emitting pixel, at least a partial region of the first groove part, and at least a partial region of the second groove part. In addition, the electrode metal layer is insulated from the semiconductor functional layer in the first groove part, and the electrode metal layer is electrically connected to the first semiconductor layer in the second groove part. In addition, a first dielectric layer is disposed between the electrode metal layer and a bottom wall of the first groove part. In addition, a part, extending from the first dielectric layer to a bottom wall of the second groove part, of the electrode metal layer is in a step shape, to reduce a risk of fracture of the electrode metal layer, and improve reliability.

In addition, for other structures of the photoelectric device in embodiments of the third aspect, refer to descriptions of related structures in the embodiments of the first aspect or the second aspect. Details are not described herein again. It should be noted that implementations of the embodiments of the third aspect may alternatively not rely on the implementations of the first aspect or the second aspect, and may alternatively be other implementations. This is not specifically limited herein.

According to a fourth aspect, an embodiment of this application further provides a light-emitting module. The light-emitting module includes a photoelectric device, a drive device, and an interconnection assembly. The drive device is located on a side, with a plurality of light-emitting pixels, of the photoelectric device. The drive device includes a first drive pad and a second drive pad. In addition, the interconnection assembly is located between the photoelectric device and the drive device. The interconnection assembly includes a first interconnection structure and a second interconnection structure. A first end of the first interconnection structure is connected to a first electrode, and a second end of the first interconnection structure is connected to the first drive pad. A first end of the second interconnection structure is connected to a second electrode, and a second end of the second interconnection structure is connected to the second drive pad.

The photoelectric device is the photoelectric device according to any one of the first aspect or the embodiments of the first aspect. Alternatively, the photoelectric device is the photoelectric device according to any one of the second aspect or the embodiments of the second aspect. Alternatively, the photoelectric device is the photoelectric device according to any one of the third aspect or the embodiments of the third aspect.

In some embodiments, an underfill structure layer is further disposed between the photoelectric device and the drive device. To be specific, the interconnection assembly is disposed in the underfill structure layer, and the photoelectric device, the interconnection assembly, and the drive device are protected by the underfill structure layer, to further improve reliability of the light-emitting module and avoid damage caused by stress. For example, a material of the underfill structure layer includes a polymer material and a filling particle. The polymer material includes, for example, but is not limited to, resin. The filling material includes, for example, but is not limited to, SiO₂ and TiO₂.

According to a fifth aspect, an embodiment of this application further provides an electronic device. The electronic device includes a circuit board and a light-emitting module. The circuit board is connected to a drive device in the light-emitting module. The light-emitting module is the photoelectric device according to any one of the fourth aspect or the embodiments of the fourth aspect.

### BRIEF DESCRIPTION OF DRAWINGS

FIG. 1 is a diagram of a structure of an electronic device according to an embodiment of this application;
FIG. 2a is a schematic top view of a structure of a photoelectric device according to an embodiment of this application;
FIG. 2b is a top view of a groove region shown in FIG. 2a;
FIG. 2c is another top view of a groove region according to an embodiment of this application;
FIG. 3a is a schematic sectional view of a structure in an AA' direction in FIG. 2a;
FIG. 3b is a schematic sectional view of a structure in a BB' direction in FIG. 2a;
FIG. 3c is a schematic sectional view of a structure in a CC' direction in FIG. 2a;
FIG. 4a to FIG. 4d are diagrams of equivalent structures of a grid pattern according to an embodiment of this application;
FIG. 5a to FIG. 5g are schematic sectional views of a structure of a photoelectric device during preparation according to an embodiment of this application;
FIG. 6a is a schematic top view of another structure of a photoelectric device according to an embodiment of this application;
FIG. 6b is a top view of a groove region shown in FIG. 6a;
FIG. 6c is another top view of a groove region according to an embodiment of this application;
FIG. 7 is a schematic sectional view of a structure in an AA' direction in FIG. 6a;
FIG. 8 is a schematic top view of another structure of a photoelectric device according to an embodiment of this application;
FIG. 9 is a schematic sectional view of a structure in an AA' direction in FIG. 8;
FIG. 10a to FIG. 10e show arrangement manners of light-emitting pixels and boss structures according to an embodiment of this application;
FIG. 11a to FIG. 11g are schematic sectional views of another structure of a photoelectric device during preparation according to an embodiment of this application;
FIG. 12 is a schematic sectional view of another structure in an AA' direction in FIG. 8;
FIG. 13 is a schematic sectional view of another structure in an AA' direction in FIG. 8;
FIG. 14 is a schematic sectional view of another structure in an AA' direction in FIG. 8;
FIG. 15 is a schematic top view of another structure of a photoelectric device according to an embodiment of this application;
FIG. 16 is a schematic sectional view of another structure in an AA' direction in FIG. 15;
FIG. 17 is a schematic top view of another structure of a photoelectric device according to an embodiment of this application;
FIG. 18a is a schematic sectional view of a structure in an AA' direction in FIG. 17;
FIG. 18b is a schematic sectional view of another structure in an AA' direction in FIG. 17;
FIG. 19 is a schematic top view of another structure of a photoelectric device according to an embodiment of this application;
FIG. 20 is a schematic sectional view of a structure in an AA' direction in FIG. 19;
FIG. 21 is a schematic top view of another structure of a photoelectric device according to an embodiment of this application;
FIG. 22 is a schematic sectional view of a structure in an AA' direction in FIG. 21;
FIG. 23 is a diagram of a structure of a light-emitting module according to an embodiment of this application;
FIG. 24 is a diagram of another structure of a light-emitting module according to an embodiment of this application;
FIG. 25 is a schematic top view of another structure of a photoelectric device according to an embodiment of this application;
FIG. 26a is a schematic sectional view of a structure in an AA' direction in FIG. 25;
FIG. 26b is a schematic sectional view of a structure in a BB' direction in FIG. 25;
FIG. 26c is a schematic sectional view of a structure in a CC' direction in FIG. 25;
FIG. 27 is a schematic top view of another structure of a photoelectric device according to an embodiment of this application;
FIG. 28a is a schematic sectional view of a structure in an AA' direction in FIG. 27;
FIG. 28b is a schematic sectional view of a structure in a BB' direction in FIG. 27; and
FIG. 28c is a schematic sectional view of a structure in a CC' direction in FIG. 27.

### Reference numerals:

1: light-emitting module; 2: circuit board; 10: photoelectric device; 20: interconnection assembly; 21: first interconnection structure; 22: second interconnection structure; 30: drive device; 31: first drive pad; 32: second drive pad; 100: substrate; 200: light-emitting pixel; 210: semiconductor functional layer; 211: first semiconductor layer; 212: light-emitting layer; 213: second semiconductor layer; 214: current extension layer; 220: first electrode; 221: first electrode connection layer; 222: first electrode pad layer; 230: electrode metal layer; 240: passivation layer; 250: buffer layer; 322: first dielectric layer; 321: second dielectric layer; 330: contact through-hole; 332: second contact hole; 333: third contact hole; 334: fourth contact hole; 400: groove region; 401: first groove part; 402: second groove part; 411: first cross region; 412: second cross region; 420: grid pattern; 510: boss structure; 520: second electrode; 521: second electrode connection layer; 522: second electrode pad layer; 610/812: distributed Bragg reflection layer; 710: first protrusion structure; 720: second protrusion structure; 810: first reflection layer; 811: first metal layer; 820: second reflection layer; 821: second metal layer; 830: contact electrode; 910: underfill structure layer; S1: first surface; S2: second surface; F0: vertical direction; F1: first direction; F2: second direction; Y221/Y332: outer boundary; AX1: first groove; AX2: second groove; AC: recess; h1: first vertical distance; h2: second vertical distance.

### DESCRIPTION OF EMBODIMENTS

To make the objectives, technical solutions, and advantages of this application clearer, the following further describes this application in detail with reference to the accompanying drawings. A specific operation method in a method embodiment may also be applied to an apparatus embodiment or a system embodiment. It should be noted that, in the descriptions of this application, "a plurality of" may be understood as "at least two". In addition, it should be understood that, in the descriptions of this application, the terms "first", "second", and the like are merely intended for distinguishing in the descriptions, but shall not be construed as indicating or implying relative importance or indicating or implying an order.

It should be noted that same reference numerals in the accompanying drawings of this application indicate same or similar structures. Therefore, repeated descriptions thereof are omitted. Expressions of positions and directions in this application are described by using the accompanying drawings as an example. However, changes may alternatively be made as needed, and all the changes fall within the protection scope of this application. The accompanying drawings in this application are merely used to illustrate relative positional relationships and do not represent an actual scale.

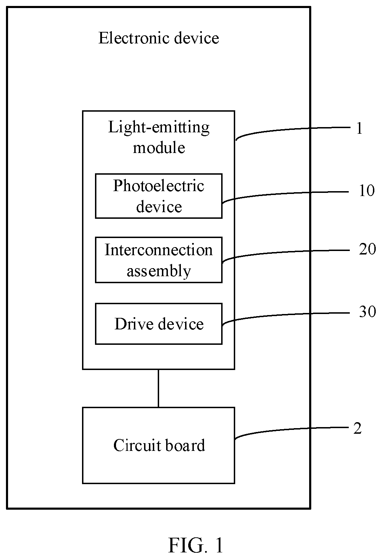

FIG. 1 is a diagram of a structure of an electronic device according to an embodiment of this application. As shown in FIG. 1, the electronic device includes a circuit board 2 and a light-emitting module 1. The light-emitting module 1 includes a photoelectric device 10, an interconnection assembly 20, and a drive device 30. The interconnection assembly 20 is located between the photoelectric device 10 and the drive device 30, and the photoelectric device 10 is connected to the drive device 30 through the interconnection assembly 20, to implement signal transmission between the photoelectric device 10 and the drive device 30. In addition, the drive device 30 is connected to the circuit board 2, to implement signal transmission between the drive device 30 and the circuit board 2, to drive the photoelectric device 10 to emit light. For example, the circuit board 2 includes, but is not limited to, a printed circuit board (Printed Circuit Board, PCB).

The electronic device in this application may be light-emitting devices used in different scenarios. For example, the electronic device is used in, but is not limited to, the following fields: the display field, the lighting field, the projection field, the vehicle field, the detection field, and the like. For example, the electronic device may be used in the display field, and the electronic device may be disposed as a display apparatus. The display apparatus includes, for example, a smartphone, a smartwatch, a tablet computer, a vehicle-mounted display, or a large-sized display. In this case, the light-emitting module may serve as a display in the display apparatus or a backlight module of a liquid crystal display. Alternatively, the display apparatus includes, for example, an augmented reality (Augmented Reality, AR) apparatus or a virtual reality (Virtual Reality, VR) apparatus. In this case, the light-emitting module may serve as an underlying light-emitting source, and light emitted by the light-emitting module is imaged through an optical waveguide after passing through a digital light processor (Digital Light Processing, DLP) or liquid crystal on silicon (Liquid Crystal on Silicon, LCOS). For example, the electronic device may alternatively be used in the projection field, and the electronic device may be disposed as a projection apparatus. In this case, the light-emitting module may serve as an underlying light-emitting source, and light emitted by the light-emitting module is imaged through an optical waveguide after passing through liquid crystal on silicon (Liquid Crystal on Silicon, LCOS). For example, the electronic device may alternatively be used in the lighting field (for example, the digital lighting field), and the electronic device may be disposed as a lamp. In this case, the light-emitting module may serve as a light source of the lamp. For example, the electronic device may alternatively be used in the vehicle field, and the electronic device may be disposed as a smart vehicle light. In this case, the light-emitting module may serve as a light source of the smart vehicle light, and the light-emitting module may be bonded to a complementary metal-oxide-semiconductor (Complementary Metal-Oxide-Semiconductor, CMOS), to implement pixel-based control on a lighting region. For example, the electronic device may alternatively be used in the detection field, and the electronic device may be disposed as a photoelectric detector (for example, an ultraviolet photoelectric detector). It can be understood that a specific implementation of the electronic device may be determined based on an actual application scenario. Examples are not exhaustively listed herein.

The following first describes in detail a photoelectric device provided in embodiments of this application with reference to Embodiment 1.

### Embodiment 1:

During actual application, a photoelectric device may be formed by using a plurality of light-emitting pixels. Usually, each light-emitting pixel includes a semiconductor functional layer, a positive electrode, and a negative electrode. The positive electrode and the negative electrode are usually disposed on a same side of the semiconductor function, and the positive electrode and the negative electrode of each light-emitting pixel are respectively connected to a positive weld leg and a negative weld leg of a drive device. This leads to a large quantity of interconnection point positions, and increases process difficulty. In view of this, a metal mesh wire is disposed in a groove region 400 between semiconductor functional layers of light-emitting pixels, the metal mesh wire is in contact with an N-type semiconductor layer in the semiconductor functional layer of each light-emitting pixel, and the metal mesh wire supplies power to the N-type semiconductor layer of each light-emitting pixel. During a process of preparation, to enable the metal mesh wire to be in contact with the N-type semiconductor layer in the groove region 400, the groove region 400 needs to have a specific width. In addition, according to a current extension requirement of the metal mesh wire, the metal mesh wire needs to have a specific metal wire width. This further leads to an increase in a width of the groove region 400 (usually, the width of the groove region 400 may reach 5 µm to 10 µm). Consequently, an active light-emitting region of the light-emitting pixel is greatly occupied by the groove region 400, and an area of the active light-emitting region of the light-emitting pixel is reduced.

Therefore, an embodiment of this application provides a photoelectric device, to greatly reduce occupation of an active light-emitting region in a light-emitting pixel by a groove region 400, and increase an area of the active light-emitting region in the light-emitting pixel. In addition, a conductive area of an electrode metal layer 230 may be further increased, to meet a current extension requirement, and enable the electrode metal layer 230 to withstand a larger current.

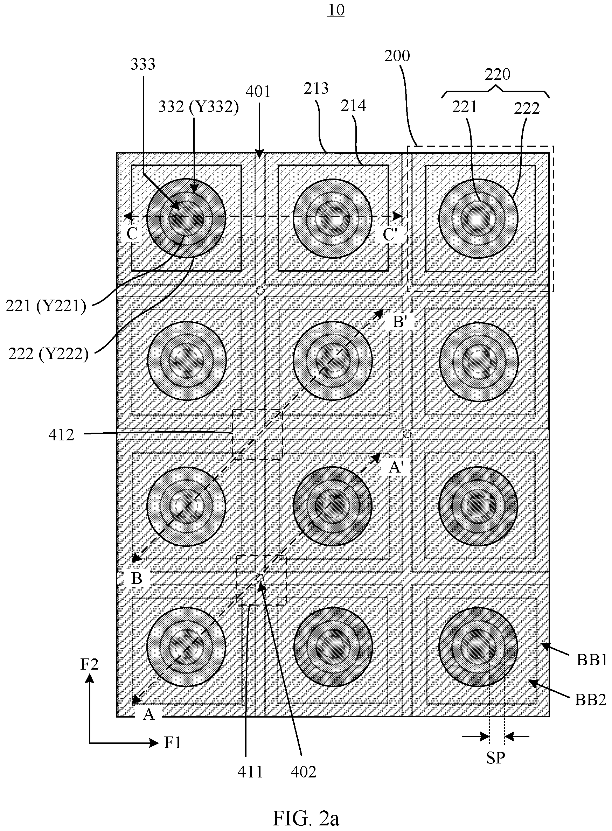

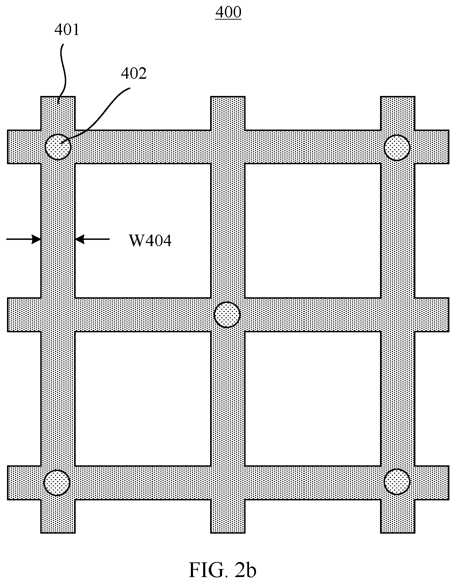

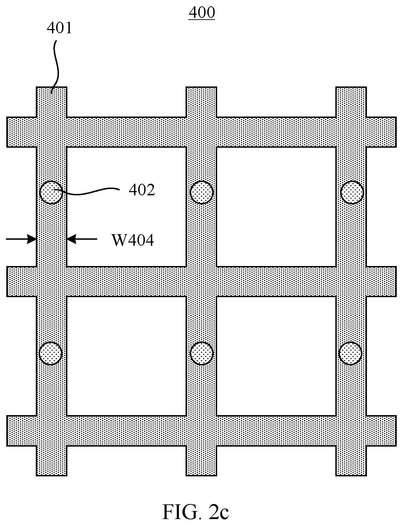

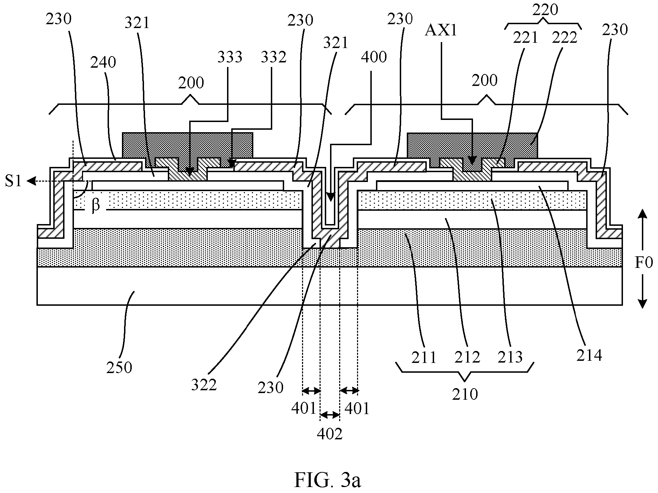

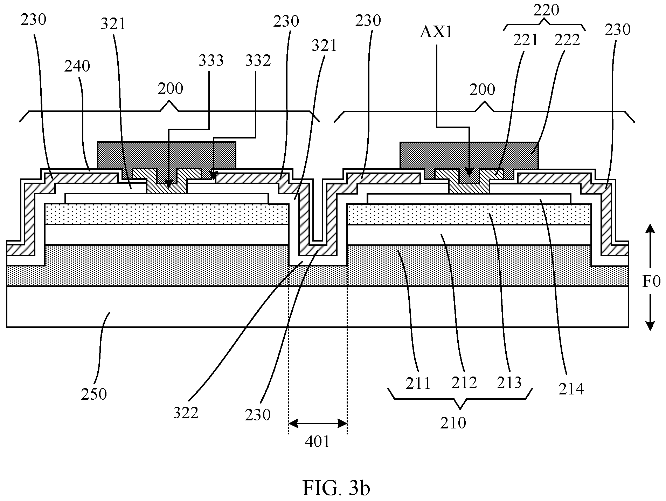

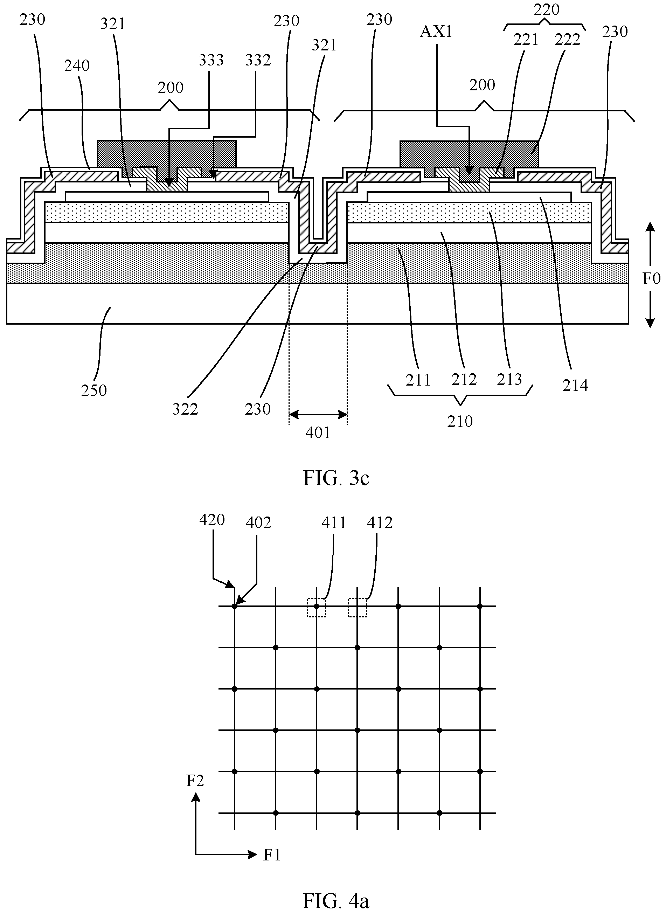

FIG. 2a is a schematic top view of a structure of a photoelectric device according to an embodiment of this application. FIG. 2b is a top view of a groove region shown in FIG. 2a. FIG. 2c is another top view of a groove region according to an embodiment of this application. FIG. 3a is a schematic sectional view of a structure in an AA' direction in FIG. 2a. FIG. 3b is a schematic sectional view of a structure in a BB' direction in FIG. 2a. FIG. 3c is a schematic sectional view of a structure in a CC' direction in FIG. 2a. As shown in FIG. 2a to FIG. 3c, the photoelectric device 10 includes a plurality of light-emitting pixels 200, a groove region 400, and an electrode metal layer 230. Each light-emitting pixel 200 includes a semiconductor functional layer 210 and a first electrode 220. Each semiconductor functional layer 210 includes a first semiconductor layer 211, a light-emitting layer 212, and a second semiconductor layer 213 that are disposed in a stacked manner. The second semiconductor layer 213 is electrically connected to the first electrode 220. The electrode metal layer 230 is electrically connected to a second electrode (not shown in FIG. 2a).

In addition, the groove region 400 is formed on the semiconductor functional layer 210, and the groove region 400 may be located between the plurality of light-emitting pixels 200. The groove region 400 may include a first groove part 401 and a second groove part 402, and the electrode metal layer 230 covers at least a partial surface of each light-emitting pixel 200, at least a partial region of the first groove part 401, and at least a partial region of the second groove part 402. In addition, the electrode metal layer 230 is insulated from the semiconductor functional layer in the first groove part 401, and the electrode metal layer 230 is electrically connected to the first semiconductor layer 211 in the second groove part 402.

In the conventional technology, a second electrode is usually a metal mesh wire, and therefore a width of a groove region 400 needs to be large. In this embodiment of this application, the electrode metal layer 230 connected to the second electrode is disposed, and the electrode metal layer 230 is electrically connected to the first semiconductor layer 211 in the second groove part 402. In this way, a voltage in the second electrode can be input to a first semiconductor layer 211 in each light-emitting pixel through the electrode metal layer 230, to supply power to the first semiconductor layer 211 in each light-emitting pixel, so that a quantity of interconnection points is reduced. In addition, the electrode metal layer 230 not only covers at least a partial region of the first groove part 401, but also covers at least a partial surface of each light-emitting pixel 200 and at least a partial region of the second groove part 402, so that a wire width of the electrode metal layer 230 is not limited by a size of the first groove part 401, and a conductive area of the electrode metal layer 230 can be increased, to reduce a voltage drop of the electrode metal layer 230. In this way, the electrode metal layer 230 can withstand a larger current, and the electrode metal layer 230 meets a current extension requirement, to improve current uniformity of the light-emitting pixel. In addition, the electrode metal layer 230 is insulated from the semiconductor functional layer in the first groove part 401. To be specific, an electrode metal layer 230 in the first groove part 401 does not need to be in contact with the first semiconductor layer 211. Therefore, no large region needs to be reserved in the first groove part 401, provided that the first groove part 401 can implement isolation between light-emitting pixels. In this way, a width of the first groove part 401 can be reduced, to greatly reduce occupation of an active light-emitting region in the light-emitting pixel by the first groove part 401, and increase an area of the active light-emitting region.

In addition, usually, a metal layer has strong light absorption. If a large area of the metal layer is in contact with the first semiconductor layer 211, light is absorbed by the metal layer through the first semiconductor layer 211, leading to a decrease in light-emitting efficiency of the device. In this embodiment of this application, the electrode metal layer 230 is insulated from the semiconductor functional layer in the first groove part 401, and the electrode metal layer 230 is in contact with the first semiconductor layer 211 in the second groove part 402 to implement an electrical connection. Compared with the conventional technology in which all electrode metal layers 230 in a groove region 400 need to be in contact with a first semiconductor layer 211, in this embodiment of this application, a proportion of an area, in direct contact with the first semiconductor layer 211, of the electrode metal layer 230 can be reduced, to reduce light absorption of the electrode metal layer 230, and improve light-emitting efficiency of the device.

Still as shown in FIG. 2a to FIG. 3c, the plurality of light-emitting pixels 200 share a first semiconductor layer 211. For example, the first semiconductor layer 211 is a film layer laid on an entire surface, a region, corresponding to the light-emitting pixel 200, of the first semiconductor layer 211 is protrudingly arranged, and a region between first semiconductor layers 211 of adjacent light-emitting pixels 200 is concave to form the groove region 400. That is, the first semiconductor layer 211 has a protruding part, and the protruding part is disposed in a region in which the light-emitting pixel 200 is located. In this case, a first semiconductor layer 211 between adjacent light-emitting pixels 200 forms a bottom wall of the groove region 400, and a side wall of the protruding region of the first semiconductor layer 211 forms at least a partial side wall of the groove region 400. In this way, first semiconductor layers 211 that are disposed in a protruding manner and that are located in different light-emitting pixels can be separated by the groove region 400.

In addition, the light-emitting layer 212 is located on the protruding part, and the second semiconductor layer 213 is disposed on the light-emitting layer 212. In this case, the side wall of the protruding region of the first semiconductor layer 211, a side wall of the light-emitting layer 212, and a side wall of the second semiconductor layer 213 form a side wall of the groove region 400. In this way, light-emitting layers 212 and second semiconductor layers 213 in different light-emitting pixels 200 can be separated by the groove region 400.

In some embodiments of this application, the first semiconductor layer 211 is an N-type semiconductor layer, and the second semiconductor layer 213 is a P-type semiconductor layer. In this case, the first electrode 220 may be disposed as a positive electrode, and the second electrode may be disposed as a negative electrode. The second semiconductor layer 213 is electrically connected to the first electrode 220, the first semiconductor layer 211 in the semiconductor functional layer 210 is electrically connected to the electrode metal layer 230, and the electrode metal layer 230 is electrically connected to the second electrode. Based on this, a first voltage is transmitted to the second semiconductor layer 213 through the first electrode 220, and a second voltage is transmitted to the first semiconductor layer 211 through the second electrode and the electrode metal layer 230, so that the light-emitting layer 212 can be driven to emit light, and the light-emitting pixel 200 emits light. In some other embodiments of this application, the first semiconductor layer 211 may alternatively be a P-type semiconductor layer, and the second semiconductor layer 213 is an N-type semiconductor layer. This is not limited herein.

The first semiconductor layer 211 may be of a single-layer structure. For example, the first semiconductor layer 211 includes a GaN layer or an AlGaN layer. Alternatively, the first semiconductor layer 211 may be of a multi-layer structure. For example, the first semiconductor layer 211 includes a combination of a GaN layer and an AlGaN layer, where one GaN layer and one AlGaN layer are alternately stacked, or a plurality of GaN layers and a plurality of AlGaN layers are alternately stacked. For example, constituent content of Al in the first semiconductor layer 211 ranges from 0% to 30%. For example, the constituent content of Al is 0%, 5%, 10%, 15%, 20%, 25%, or 30%. This is not limited herein. In addition, a thickness of the first semiconductor layer 211 ranges from 200 nm to 5 µm. For example, the thickness of the first semiconductor layer 211 is 200 nm, 500 nm, 1 µm, 1.5 µm, 2 µm, 2.5 µm, 3 µm, 3.5 µm, 4 µm, 4.5 µm, or 5 µm. This is not limited herein.

The light-emitting layer 212 is of a multi-layer structure. For example, the light-emitting layer 212 may include two or three of an InGaN layer, a GaN layer, and an AlGaN layer, or any combination thereof formed through stacking. For example, constituent content of In in the light-emitting layer 212 ranges from 0% to 50%. For example, the constituent content of In is 0%, 5%, 10%, 15%, 20%, 25%, 30%, 35%, 40%, 45%, or 50%. This is not limited herein. In addition, constituent content of Al ranges from 0% to 50%. For example, the constituent content of Al is 0%, 5%, 10%, 15%, 20%, 25%, 30%, 35%, 40%, 45%, or 50%. This is not limited herein. In addition, a thickness of the light-emitting layer 212 ranges from 50 nm to 500 nm. For example, the thickness of the light-emitting layer 212 is 50 nm, nm, 150 nm, 200 nm, 250 nm, 300 nm, 350 nm, 400 nm, 450 nm, or 500 nm. This is not limited herein.

The second semiconductor layer 213 may be of a single-layer structure. For example, the second semiconductor layer 213 includes a GaN layer or an AlGaN layer. Alternatively, the second semiconductor layer 213 may be of a multi-layer structure. For example, the second semiconductor layer 213 includes a combination of a GaN layer and an AlGaN layer, where one GaN layer and one AlGaN layer are alternately stacked, or a plurality of GaN layers and a plurality of AlGaN layers are alternately stacked. For example, constituent content of Al in the second semiconductor layer 213 ranges from 0% to 30%. For example, the constituent content of Al is 0%, 5%, 10%, 15%, 20%, 25%, or 30%. This is not limited herein. In addition, a thickness of the second semiconductor layer 213 ranges from 50 nm to 500 nm. For example, the thickness of the second semiconductor layer 213 is 50 nm, 100 nm, 150 nm, 200 nm, 250 nm, 300 nm, 350 nm, 400 nm, 450 nm, or 500 nm. This is not limited herein.

As shown in FIG. 3a to FIG. 3c, the photoelectric device 10 further includes a buffer layer 250, and the buffer layer 250 is located on a side, facing away from the light-emitting 212, of the first semiconductor layer 211. For example, the buffer layer 250 may be of a single-layer structure. For example, the buffer layer 250 includes an AlN layer, a GaN layer, or an AlGaN layer. Alternatively, the buffer layer 250 may be of a multi-layer structure. For example, the buffer layer 250 includes a combination of two or three of an AlN layer, a GaN layer, and an AlGaN layer. For example, a thickness of the buffer layer 250 ranges from 200 nm to 10 µm. For example, the thickness of the buffer layer 250 is 200 nm, 500 nm, 800 nm, 1 µm, 1.5 µm, 5 µm, or 10 µm. This is not limited herein. It can be understood that the area of the active light-emitting region in the light-emitting pixel may be an area of an orthographic projection of the light-emitting layer on the buffer layer 250.

Based on the foregoing content, the light-emitting pixel 200 may be formed as a GaN-type LED. Further, a micro light-emitting diode (Micro-LED) and a mini light-emitting diode (Mini-LED) not only have characteristics of a light-emitting diode (Light-Emitting Diode, LED) such as a long service life, high luminance, and low power consumption, but also have advantages such as an ultra-high resolution, high color saturation, and a nanosecond-level response speed. Therefore, in some other embodiments of this application, the light-emitting pixel 200 may alternatively be formed as a GaN-type micro-LED or a GaN-type mini-LED.

In some embodiments of this application, as shown in FIG. 3a to FIG. 3c, the electrode metal layer 230 further covers the side wall of the protruding part of the first semiconductor layer 211, the side wall of the light-emitting layer 212, and the side wall of the second semiconductor layer 213, to further increase an area of the electrode metal layer 230 and further improve current uniformity. For example, the electrode metal layer 230 may fully cover the side wall of the protruding part of the first semiconductor layer 211, the side wall of the light-emitting layer 212, and the side wall of the second semiconductor layer 213. In some other embodiments of this application, the electrode metal layer 230 may alternatively cover only a partial region of any one of the side wall of the protruding part of the first semiconductor layer 211, the side wall of the light-emitting layer 212, and the side wall of the second semiconductor layer 213. In other words, the electrode metal layer 230 does not fully cover the side wall. For example, if an orthographic projection of the semiconductor functional layer 210 on the buffer layer 250 is in a rectangular shape, a region that is not covered by the electrode metal layer 230 may be a corner between two adjacent side wall surfaces of the semiconductor functional layer 210, or a region that is not covered by the electrode metal layer 230 may be any surface of a side wall of the semiconductor functional layer 210. For a semiconductor functional layer 210 in another shape, refer to the foregoing descriptions for understanding. Details are not described again.

Still as shown in FIG. 3a to FIG. 3c, to insulate the electrode metal layer 230 from the side wall of the protruding part of the first semiconductor layer 211, the side wall of the light-emitting layer 212, and the side wall of the second semiconductor layer 213, a second dielectric layer 321 may be further disposed between the electrode metal layer 230 and the side wall of the protruding part of the first semiconductor layer 211, the side wall of the light-emitting layer 212, and the side wall of the second semiconductor layer 213. For example, the second dielectric layer 321 is of a single-layer dielectric thin-film structure or a multi-layer dielectric thin-film composite structure, and a material of the single-layer dielectric thin-film structure and a material of the multi-layer dielectric thin-film composite structure include, but are not limited to, SiO₂, Al₂O₃, MgF₂, TiO₂, Ta₂O₅, ZrO₂, SiN, and the like.

Still as shown in FIG. 3a to FIG. 3c, the light-emitting pixel 200 further includes a current extension layer 214, the current extension layer 214 is disposed on the second semiconductor layer 213, the second dielectric layer 321 further covers a side wall of the current extension layer 214, and the electrode metal layer 230 further covers a second dielectric layer 321 on the side wall of the current extension layer 214. In this way, an area of the electrode metal layer 230 is further increased, to further improve current uniformity. For example, the current extension layer 214 includes one or a combination of a metal conducting layer and a transparent conducting layer, to improve current uniformity. For example, the metal conducting layer includes one or more of Ni, Ag, and Au. For example, the metal conducting layer includes Ni and Ag, or the metal conducting layer includes Ni and Au. For example, the transparent conducting layer is a metal-oxide transparent conducting thin-film. For example, the metal-oxide transparent conducting thin-film includes indium tin oxide (ITO) or indium zinc oxide (IZO).

Further, when the current extension layer 214 is disposed as the transparent conducting layer, an average value of a refractive index of the current extension layer 214 and a refractive index of the second dielectric layer 321 may be less than a refractive index of the first semiconductor layer 211, and the average value of the refractive index of the current extension layer 214 and the refractive index of the second dielectric layer 321 may be less than a refractive index of the second semiconductor layer 213. In this way, the current extension layer 214 and the second dielectric layer 321 can be further reused as reflection layers to reflect a part of light, to further improve light output efficiency of the device. In addition, when the electrode metal layer 230 is disposed as a metal layer, the current extension layer 214, the second dielectric layer 321, and the electrode metal layer 230 may be further combined, to mitigate low light-emitting efficiency caused by absorbing a part of light by the metal layer, and further reduce an overall thickness of the light-emitting pixel 200, to facilitate miniaturization of the light-emitting pixel 200. In addition, in consideration of the thickness of the light-emitting pixel 200, a total thickness of the current extension layer 214 and the second dielectric layer 321 may be set to 200 nm to 1000 nm. For example, the total thickness of the current extension layer 214 and the second dielectric layer 321 is set to 200 nm, 400 nm, 600 nm, 800 nm, or 1000 nm. This is not limited herein. In addition, when the current extension layer 214 is disposed as the metal conducting layer, light emitted by the light-emitting layer 212 to a first surface S1 can be directly reflected, to improve light output efficiency of the device.

Usually, a metal material has a high reflectivity. As shown in FIG. 3a to FIG. 3c, the electrode metal layer 230 may be further reused as a reflection layer to reflect emergent light of the semiconductor functional layer 210 to a light exit side as much as possible, to improve light output efficiency of the device. For example, the electrode metal layer 230 may be a single layer of metal or a plurality of layers of metal. During actual application, an appropriate metal material, for example, Al or Ag, may be selected based on a reflectivity needed for a wavelength of emergent light of the light-emitting pixel 200. Alternatively, the electrode metal layer 230 may be disposed as an appropriate composite metal laminated layer according to a current conducting requirement. For example, the electrode metal layer 230 is disposed as metal, for example, Au, Al, Ti, Pt, Ni, Cr or Ag, or a metal semiconductor functional layer formed by combining the metal. To improve reflection performance, a metal material, for example, Al and Ag, in the metal semiconductor functional layer, that has a high reflectivity for emergent light of the light-emitting pixel 200 may be placed close to the second dielectric layer 321. Further, to improve adhesion and electrical contact performance of the metal semiconductor functional layer, a contact layer or an adhesion layer is disposed between the metal material with a high reflectivity and the second dielectric layer 321, to increase a bonding force between the electrode metal layer 230 and the second dielectric layer 321 and reduce contact resistance. A material of the contact layer or the adhesion layer is Ti, Cr, Ni, or the like, and a thickness of the contact layer or the adhesion layer ranges from 0.1 nm to 5 nm. For example, the thickness of the contact layer or the adhesion layer is 0.1 nm, 0.5 nm, 1 nm, 1.5 nm, 2 nm, 2.5 nm, 3 nm, 3.5 nm, 4 nm, 4.5 nm, or 5 nm. This is not limited herein. It can be understood that the light exit side is a side, facing away from an active layer, of the first semiconductor layer 211. In addition, when the electrode metal layer 230 is disposed as a metal layer, a heat dissipation function can be further provided, to avoid local overheating, and provide higher reliability under impact of heat circulation in a subsequent process.

Still as shown in FIG. 3a to FIG. 3c, a part of the electrode metal layer 230 that extends from the side wall of the second semiconductor layer 213 to a side, facing away from the light-emitting layer, of the current extension layer 214 is in a double-step shape. This facilitates stress release, reduces a risk that the electrode metal layer 230 breaks when extending from the side wall of the second semiconductor layer 213 to the current extension layer 214, and improves reliability. For example, a surface, facing away from the light-emitting layer 212, of the second semiconductor layer 213 has a first region BB1 and a second region BB2, the first region BB1 surrounds the second region BB2, and the current extension layer 214 covers the second region BB2. In addition, the second dielectric layer 321 further covers the first region BB1. In this case, the second dielectric layer 321 extends along the side wall of the second semiconductor layer 213 to the first region BB1, and then extends to the side wall of the current extension layer 214 through the first region BB1. In addition, the electrode metal layer 230 further covers a second dielectric layer 321 located in the first region BB1. In this case, the electrode metal layer 230 extends along the second dielectric layer 321 to the side wall of the current extension layer 214.

Still as shown in FIG. 3a to FIG. 3c, a surface, facing away from the second semiconductor layer 213, of the current extension layer 214 is a first surface S1, and the electrode metal layer 230 further extends to cover the first surface S1 and forms a second contact hole 332 on the first surface S1 in an enclosed manner, to further increase an area of the electrode metal layer 230 and further improve current uniformity. In addition, the second dielectric layer 321 also extends to cover the first surface S1 and forms a third contact hole 333 on an inner side of the second contact hole 332 in an enclosed manner. To be specific, the electrode metal layer 230 forms the second contact hole 332 in an enclosed manner at a specified spacing SP from the third contact hole 333. Based on this, the first electrode 220 can be electrically connected to the second semiconductor layer 213 through the second contact hole 332 and the third contact hole 333, and the first electrode 220 is insulated from the electrode metal layer 230. In this way, the electrode metal layer 230 is insulated from the semiconductor functional layer 210 through the second dielectric layer 321, and adhesion of the electrode metal layer 230 is improved. In addition, when the electrode metal layer 230 is a metal layer, emergent light of the first surface S1 of the semiconductor functional layer 210 can be further reflected to the light exit side as much as possible, to improve light output efficiency of the device. In addition, the specified spacing SP may be determined according to a requirement of an actual application scenario. This is not limited herein.

In addition, in this way, a part, extending from the side wall of the second semiconductor layer 213 to the first surface S1, of the second dielectric layer 321 can be further in a double-step shape, to reduce a risk of fracture of the second dielectric layer 321. Because the electrode metal layer 230 extends along a surface of the second dielectric layer 321 to the second contact hole 332, a part, extending from the side wall of the second semiconductor layer 213 to the first surface S1, of the electrode metal layer 230 may also be in a double-step shape, to reduce a risk of fracture of the electrode metal layer 230. In addition, in this way, the electrode metal layer 230 and the semiconductor functional layer 210 can be further conformal, so that the electrode metal layer 230 can cover a gap between light-emitting pixels 200. When the electrode metal layer 230 is disposed as a metal layer, emergent light of the side wall of the semiconductor functional layer 210 and the first surface S1 can be further reflected to the light exit side as much as possible, to improve reflection efficiency and improve light-emitting efficiency of the light-emitting pixel 200.

In some embodiments of this application, an electrode metal layer 230 on the first surface S1 may be of a whole-plane structure, and the second contact hole 332 is further formed in the whole-plane structure. To be specific, a region, in a region in which the second contact hole 332 is located, of the first surface S1 is exposed from the electrode metal layer 230. Alternatively, in addition to the second contact hole 332, another contact hole or opening may be further formed in the whole-plane structure. To be specific, both a region, in a region in which the second contact hole 332 is located, of the first surface S1 and a region, in a region in which the another contact hole or opening is located, of the first surface S1 are exposed from the electrode metal layer 230. For example, if an orthographic projection of the semiconductor functional layer 210 is in a rectangular shape, a region that is not covered by the electrode metal layer 230 may be a region from a corner between two adjacent side wall surfaces of the semiconductor functional layer 210 to the second contact hole 332, or a region that is not covered by the electrode metal layer 230 may be a region from any surface of a side wall of the semiconductor functional layer 210 to the second contact hole 332. For a semiconductor functional layer 210 in another shape, refer to the foregoing descriptions for understanding. Details are not described again.

Still as shown in FIG. 2a to FIG. 3c, the first electrode 220 may include a first electrode connection layer 221 and a first electrode pad layer 222 that are connected to each other. The first electrode connection layer 221 is disposed between the first electrode pad layer 222 and the current extension layer 214. The first electrode connection layer 221 is connected to the current extension layer 214 through the second contact hole 332 and the third contact hole 333, so that the first electrode connection layer 221 is electrically connected to the second semiconductor layer 213 through the current extension layer 214. For example, a material of the first electrode connection layer 221 and a material of the first electrode pad layer 222 each may include one or a combination of Au, AL, Ti, Pt, Ni, Cr, Ag, Sn, and AuSn. The material of the first electrode pad layer 222 may be AuSn, to reduce contact resistance and improve connection reliability.

As shown in FIG. 2a to FIG. 3c, in a stacking direction F0 of the light-emitting layer 212 and the second semiconductor layer 213, the first electrode connection layer 221 has an outer boundary Y221, the second contact hole 332 also has an outer boundary Y332, and a spacing between the outer boundary Y221 and the outer boundary Y332 may be greater than 0. In addition, in the stacking direction F0, the first electrode connection layer 221 may alternatively be disposed in the second contact hole 332. In this way, the first electrode connection layer 221 is recessed in the second contact hole 332, and there is a gap between the first electrode connection layer 221 and an electrode metal layer 230 on a side wall of the second contact hole 332, to insulate the first electrode connection layer 221 from the electrode metal layer 230.

Further, the first electrode connection layer 221 and the electrode metal layer 230 are disposed at different layers, and a passivation layer 240 is disposed between the first electrode connection layer 221 and the electrode metal layer 230. The passivation layer 240 further covers the electrode metal layer 230, and the passivation layer 240 extends on the first surface S1 and stops at the third contact hole 333. In this way, the first electrode connection layer 221 can cover a bottom wall of the third contact hole 333, and the first electrode connection layer 221 further extends along the side wall of the third contact hole 333 to a periphery of an opening of the third contact hole 333. In this way, a part, extending from the bottom wall of the third contact hole 333 to the periphery of the opening of the third contact hole 333, of the first electrode connection layer 221 can be in a step shape, to reduce a risk of fracture of the first electrode connection layer 221, and improve reliability. In addition, the periphery of the opening of the third contact hole 333 is a small part of an edge of the opening of the third contact hole 333. Alternatively, the first electrode connection layer 221 may be formed when the electrode metal layer 230 is formed, to be specific, the first electrode connection layer 221 and the electrode metal layer 230 are formed at a same layer by using a same material, to reduce preparation difficulty of a process. In addition, to further insulate the first electrode connection layer 221 from the electrode metal layer 230, the electrode metal layer 230 may be covered with the passivation layer 240, and a gap between the first electrode connection layer 221 and an electrode metal layer 230 on a side wall of the second groove part 402 is filled with the passivation layer 240. In addition, a specific value of a spacing between an outer boundary of an orthographic projection Y221 of the first electrode and an outer boundary of an orthographic projection Y332 of the second contact hole may be determined according to a requirement of an actual application scenario. This is not limited herein.

As shown in FIG. 2a to FIG. 3c, in the stacking direction F0, because there is a gap between the first electrode connection layer 221 and the electrode metal layer 230, the first electrode pad layer 222 covers the second contact hole 332, to further improve light-emitting efficiency. In this way, the first electrode pad layer 222 is used to cover the gap between the first electrode connection layer 221 and the electrode metal layer 230, so that light emitted by the light-emitting layer 212 toward a side of the current extension layer 214 is reflected to the light exit side as much as possible, to improve reflection efficiency. Further, a part of the first electrode pad layer 222 may cover the second contact hole 332, or all of the first electrode pad layer 222 may cover the second contact hole 332.

In addition, to insulate the first electrode pad layer 222 from the electrode metal layer 230, the passivation layer 240 is disposed between the first electrode pad layer 222 and the electrode metal layer 230. Further, as shown in FIG. 3a to FIG. 3c, a profile of the first electrode connection layer 221 in the stacking direction F0 has a first groove AX1, and the first groove AX1 is filled with a partial region of the first electrode pad layer 222. In this way, the partial region of the first electrode pad layer 222 is embedded in the first groove AX1 to form a step-shaped pad, to improve reliability.

Still as shown in FIG. 3a to FIG. 3c, the first electrode 220 covers at least a partial region of the first surface S1. In addition, there is an included angle β between a side wall of the semiconductor functional layer 210 and the first surface S1, the included angle β faces a side of the semiconductor functional layer 210, and the included angle β is set to a right angle. It should be noted that the right angle defined in this embodiment of this application is not limited to an absolute 90-degree relationship, a non-absolute 90-degree relationship caused by impact of an assembly tolerance, a design tolerance, structural flatness, or other factors is allowed, and an error within a small angle range is allowed. For example, 89 degrees to 91 degrees may be understood as a 90-degree relationship within an assembly error range, and so on. Details are not described again. It can be understood that the side wall, corresponding to the included angle β, of the semiconductor functional layer 210 includes the side wall of the protruding part of the first semiconductor layer 211, the side wall of the light-emitting layer 212, and the side wall of the second semiconductor layer 213.

Still as shown in FIG. 2a to FIG. 3c, the first groove part 401 is located between adjacent light-emitting pixels 200, and the first groove part 401 further surrounds the second groove part 402 and is in communication with the second groove part 402. In this way, the electrode metal layer 230 can extend in the first groove part 401 and the second groove part 402.

In some embodiments of this application, the electrode metal layer 230 may fully cover a bottom wall of the first groove part 401. In other words, all regions of the bottom wall of the first groove part 401 are covered by the electrode metal layer 230. In some other embodiments of this application, the electrode metal layer 230 may alternatively cover only a partial region of a bottom wall of the first groove part 401. In other words, the electrode metal layer 230 does not cover all regions of the bottom wall of the first groove part 401, provided that it is ensured that the electrode metal layer 230 can be connected to the first semiconductor layer 211.

In some embodiments of this application, the electrode metal layer 230 may fully cover a bottom wall of the second groove part 402, to increase a contact area between the electrode metal layer 230 and the first semiconductor layer 211. In some other embodiments of this application, the electrode metal layer 230 may alternatively cover only a partial region of a bottom wall of the second groove part 402. In other words, the electrode metal layer 230 does not cover all of the bottom wall of the second groove part 402, provided that the electrode metal layer 230 can be electrically connected to the first semiconductor layer 211.

In some embodiments of this application, as shown in FIG. 3a to FIG. 3c, a first dielectric layer 322 is disposed between the electrode metal layer 230 and the bottom wall of the first groove part 401. To be specific, all of the bottom wall of the first groove part 401 is covered by the first dielectric layer 322, the bottom wall of the second groove part 402 is not covered by the first dielectric layer 322, and the bottom wall of the second groove part 402 is covered by the electrode metal layer 230. It should be noted that, when the first dielectric layer 322 is disposed, the electrode metal layer 230 fully covering the first dielectric layer 322 may also be equivalent to the electrode metal layer 230 covering all regions of the bottom wall of the first groove part 401. Further, the first dielectric layer 322 and the second dielectric layer 321 may be formed by using a same film layer. To be specific, the first dielectric layer 322 and the second dielectric layer 321 are disposed at a same layer by using a same material, and the first dielectric layer 322 and the second dielectric layer 321 are of an integrated structure.

It can be understood that, as shown in FIG. 2b, the second groove part 402 is not provided in all of the first groove part 401, and the second groove part 402 is provided only in a partial region. A dimension W404 of a first groove part 401 that is not provided with the second groove part 402 may be reduced. For example, W404 may be less than or equal to 2 µm. This can increase the area of the active light-emitting region. For example, W404 may be set to 2 µm, 1.8 µm, or 1.5 µm. A specific value of W404 may be determined based on an actual application scenario. This is not limited herein.

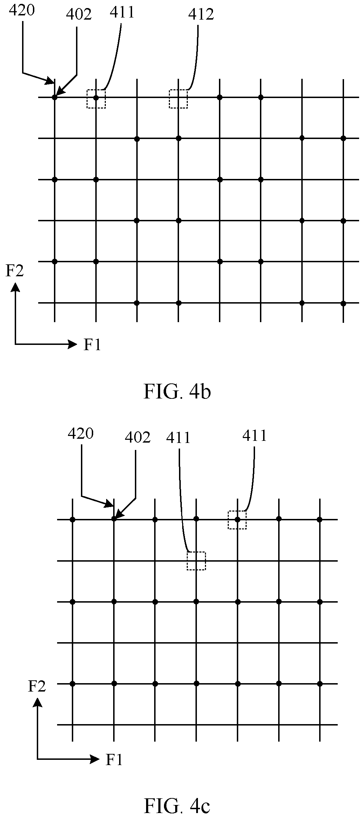

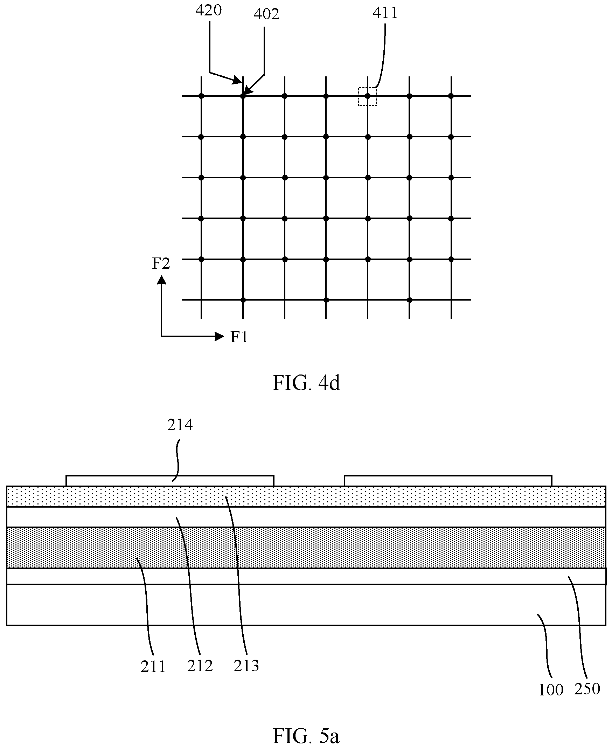

As shown in FIG. 2a and FIG. 2b, the light-emitting pixels 200 are disposed at spacings and arranged in an array, so that the groove region 400 is of a grid pattern 420. For example, FIG. 2c is another top view of a groove region according to an embodiment of this application. The second groove part 402 may be arranged on at least a part of grid lines in the grid pattern 420. Alternatively, as shown in FIG. 2a, FIG. 2b, and FIG. 3b, the second groove part 402 may be arranged in at least a part of grid cross regions in the grid pattern 420. For example, as shown in FIG. 2a and FIG. 2b, the second groove part 402 may be arranged in a part of grid cross regions in the grid pattern 420. For example, grid cross regions in the grid pattern 420 include a plurality of first cross regions 411 and a plurality of second cross regions 412. The first cross region 411 is provided with the second groove part 402. To be specific, the first cross region 411 is provided with both the first groove part 401 and the second groove part 402, and the first groove part 401 in the first cross region 411 surrounds the second groove part 402. The second cross region 412 is not provided with the second groove part 402. To be specific, the second cross region is the first groove part 401. For example, FIG. 4a is a diagram of an equivalent structure of a grid pattern according to an embodiment of this application. First cross regions 411 and second cross regions 412 may be alternately arranged in a first direction F1, and the first cross regions 411 and the second cross regions 412 are further alternately arranged in a second direction F2. The first direction F1 and the second direction F2 cross each other. In this way, the first cross regions 411 and the second cross regions 412 can be arranged in a checkerboard form, so that the first cross regions 411 and the second cross regions 412 can be dispersedly arranged as evenly as possible, to improve uniformity of electric conduction. Alternatively, FIG. 4b is a diagram of another equivalent structure of a grid pattern according to an embodiment of this application. Alternatively, two first cross regions 411 and two second cross regions 412 may be alternately arranged in a first direction F1, and two first cross regions 411 and two second cross regions 412 are alternately arranged in a second direction F2. Certainly, alternatively, three or more first cross regions 411 and three or more second cross regions 412 may be alternately arranged in a first direction F1, and three or more first cross regions 411 and three or more second cross regions 412 are alternately arranged in a second direction F2. This is not limited herein. Alternatively, FIG. 4c is a diagram of another equivalent structure of a grid pattern according to an embodiment of this application. Alternatively, a row of cross regions arranged in a first direction F1 may be set as first cross regions 411, another row of cross regions arranged in the first direction F1 are set as second cross regions 412, and first cross regions 411 and second cross regions 412 are alternately arranged in a second direction F2. Alternatively, FIG. 4d is a diagram of another equivalent structure of a grid pattern according to an embodiment of this application. Alternatively, the second groove part 402 may be arranged in all grid cross regions in the grid pattern 420. It should be noted that FIG. 4a to FIG. 4d show merely some example arrangement manners of the first cross regions 411 and the second cross regions 412, and other arrangement manners of the first cross regions 411 and the second cross regions 412 are not exhaustively listed herein. In addition, the first direction F1 and the second direction F2 are parallel to a plane on which a substrate 100 is located, and there is an included angle between the first direction F1 and the second direction F2, where the included angle may be a right angle, an acute angle, or an obtuse angle. If the included angle is a right angle, the first direction F1 is perpendicular to the second direction F2.

It can be understood that, as shown in FIG. 2b, the second groove part 402 is arranged in the grid cross region, and therefore all grid lines may be arranged as the first groove part 401. In this case, a dimension W401 of the first groove part 401 arranged on the grid lines can be reduced. For example, W401 may be less than or equal to 2 µm. This can increase the area of the active light-emitting region. For example, W401 may be set to 2 µm, 1.8 µm, or 1.5 µm. A specific value of W401 may be determined based on an actual application scenario. This is not limited herein.

In some embodiments of this application, a proportion of the first groove part 401 in the groove region 400 may be greater than or equal to 50%, and the proportion of the first groove part 401 in the groove region 400 is less than 100%. For example, the proportion of the first groove part 401 in the groove region 400 may be set to 50%, 60%, 70%, 80%, or 90%. A specific value of the proportion may be determined according to a requirement of an actual application scenario. This is not limited herein.

In some embodiments of this application, a proportion of the second groove part 402 in the groove region 400 may be greater than 0, and the proportion of the second groove part 402 in the groove region 400 is less than or equal to 50%. For example, the proportion of the second groove part 402 in the groove region 400 may be set to 10%, 20%, 30%, 40%, or 50%. A specific value of the proportion may be determined according to a requirement of an actual application scenario. This is not limited herein.

In some embodiments of this application, a coverage area of the electrode metal layer 230 may account for 30% to 99% of a total area of the entire photoelectric device. 30% to 70% corresponds to an application scenario with a common current, and 70% to 99% corresponds to an application scenario with a large current. In addition, in some extreme cases, the coverage area of the electrode metal layer 230 may account for 99% of the total area of the entire photoelectric device.

An electrode metal layer 230 that covers the second groove part 402 is named a first electrode metal layer 230 part. In this case, a proportion of an area of the first electrode metal layer 230 part in a total area of the electrode metal layer 230 is less than or equal to 70%. Further, the proportion of the area of the first electrode metal layer 230 part in the total area of the electrode metal layer 230 is less than or equal to 30%. For example, the proportion of the area of the first electrode metal layer 230 part in the total area of the electrode metal layer 230 is less than or equal to 70%, 60%, 50%, 40%, 30%, or 20%. This is not limited herein.

An electrode metal layer 230 that covers the first groove part 401 is named a second electrode metal layer 230 part. In this case, a proportion of an area of the second electrode metal layer 230 part in the total area of the electrode metal layer 230 is less than or equal to 30%. Further, the proportion of the area of the second electrode metal layer 230 part in the total area of the electrode metal layer 230 is less than or equal to 70%. For example, the proportion of the area of the second electrode metal layer 230 part in the total area of the electrode metal layer 230 is greater than or equal to 30%, 40%, 50%, 60%, 70%, 80%, or 90%. This is not limited herein.

In addition, a shape of the second groove part 402 is not limited in this application. For example, the shape of the second groove part 402 includes but is not limited to a circular shape, a rectangular shape, a polygonal shape, and the like.

Preparation of the structure of the photoelectric device shown in FIG. 2a to FIG. 3c is used as an example. A preparation method for a photoelectric device according to an embodiment of this application may include the following content.

FIG. 5a is a schematic sectional view of a structure of a photoelectric device during preparation according to an embodiment of this application. For example, a substrate 100 is provided. The substrate 100 includes, for example, but is not limited to, a Si substrate 100, a SiC substrate 100, a sapphire substrate 100, or a GaN substrate 100. A buffer layer 250, a first semiconductor layer 211, a light-emitting layer 212, and a second semiconductor layer 213 are sequentially epitaxially formed on the substrate 100. Then a current extension layer 214 is formed through deposition.

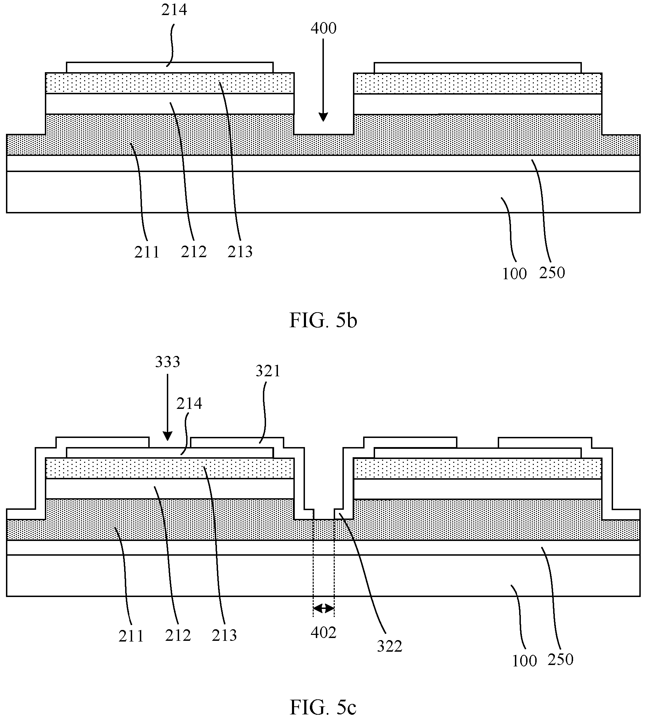

FIG. 5b is a schematic sectional view of another structure of a photoelectric device during preparation according to an embodiment of this application. For example, the first semiconductor layer 211, the light-emitting layer 212, and the second semiconductor layer 213 are patterned through a patterning process to form a recess in the first semiconductor layer 211. The light-emitting layer 212 is formed on a side, facing away from the substrate 100, of a protruding part of the first semiconductor layer 211, and the second semiconductor layer 213 is formed on a side, facing away from the substrate 100, of the light-emitting layer 212.

FIG. 5c is a schematic sectional view of another structure of a photoelectric device during preparation according to an embodiment of this application. For example, a dielectric layer is formed through deposition on a side, facing away from the substrate 100, of the current extension layer 214, and the dielectric layer includes a second dielectric layer 321 and a first dielectric layer 322. Then the dielectric layer is patterned through a patterning process, to expose a second groove part 402 and form a third contact hole 333.

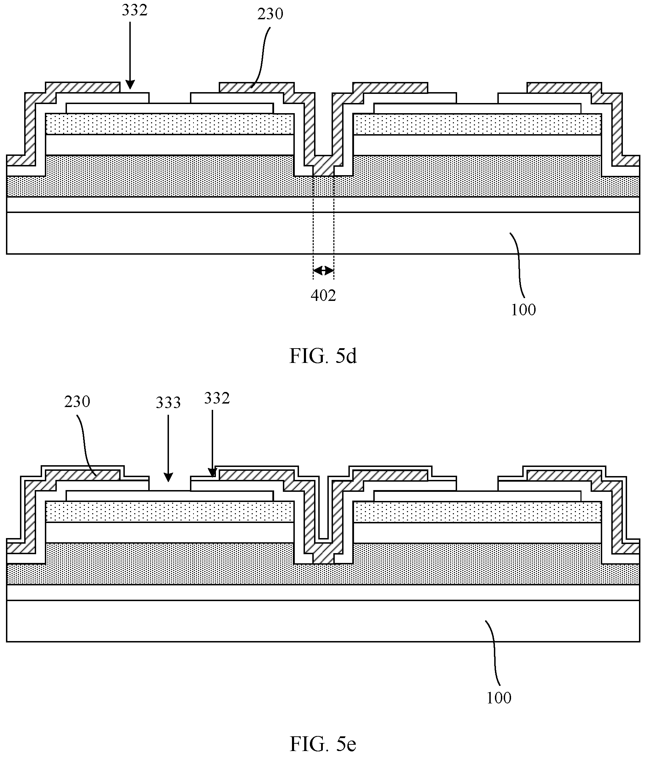

FIG. 5d is a schematic sectional view of another structure of a photoelectric device during preparation according to an embodiment of this application. For example, a metal material is deposited on a side, facing away from the substrate 100, of the dielectric layer to form an electrode metal layer 230, and the electrode metal layer 230 is in contact with the first semiconductor layer 211 in the second groove part 402. Then the electrode metal layer 230 is patterned through a patterning process to form a second contact hole 332 that passes through the electrode metal layer 230.

FIG. 5e is a schematic sectional view of another structure of a photoelectric device during preparation according to an embodiment of this application. For example, a passivation layer 240 is formed through deposition on a side, facing away from the substrate 100, of the metal layer, and the third contact hole 333 is exposed.

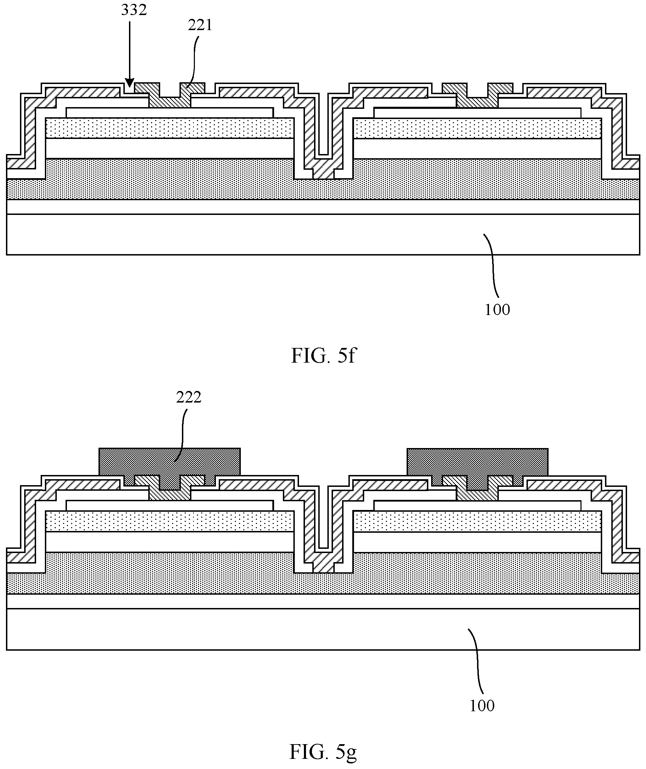

FIG. 5f is a schematic sectional view of another structure of a photoelectric device during preparation according to an embodiment of this application. For example, a first electrode connection layer 221 is formed through deposition on a side, facing away from the substrate 100, of the passivation layer 240, and the first electrode connection layer 221 is in contact with the current extension layer 214 on the semiconductor functional layer 210.

As shown in FIG. 5g, a first electrode pad layer 222 is formed on the first electrode connection layer 221, and the first electrode pad layer 222 is connected to the first electrode connection layer 221.

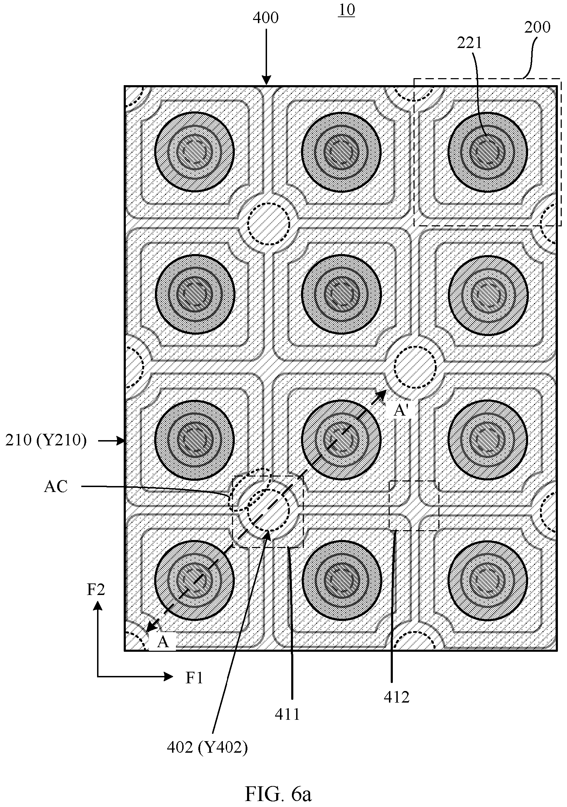

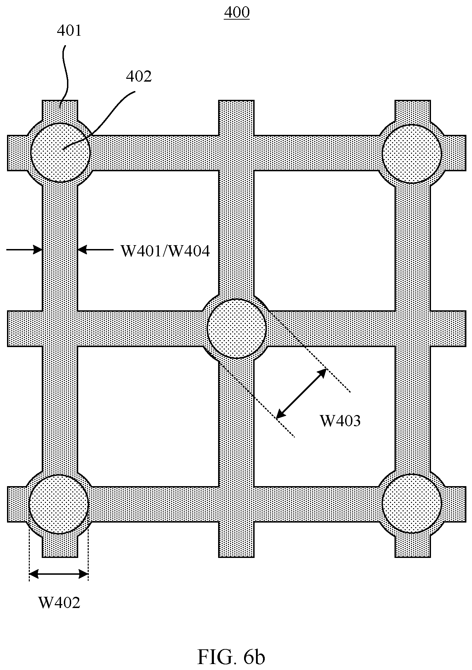

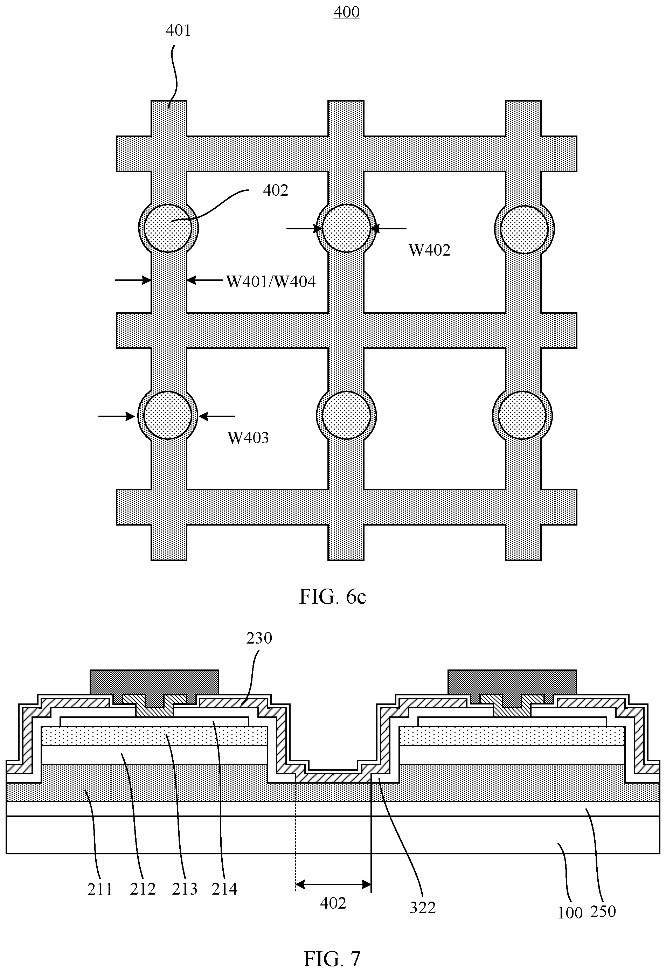

FIG. 6a is a schematic top view of another structure of a photoelectric device according to an embodiment of this application. FIG. 6b is a top view of a groove region shown in FIG. 6a. FIG. 6c is another top view of a groove region according to an embodiment of this application. FIG. 7 is a schematic sectional view of a structure in an AA' direction in FIG. 6a. As shown in FIG. 6a to FIG. 7, the photoelectric device in this embodiment is obtained through variation based on the photoelectric device in the foregoing embodiments. A same part between the photoelectric devices is not described herein again. A difference between the photoelectric devices lies in: A first dimension W403 exists between side walls of a groove region with a second groove part 402, and a second dimension W401 exists between side walls of a groove region with a first groove part, where a maximum value of the first dimension W403 is greater than a maximum value of the second dimension W401. In this way, a size of the first groove part in the groove region can be reduced, and specific space is reserved in the groove region for the second groove part, to increase an area of electrical connection between an electrode metal layer and a first semiconductor layer, and improve reliability of power supply.

For example, as shown in FIG. 6a, both the first dimension W403 and the second dimension W401 may be widths in different directions. For example, the second dimension W401 is a width in a first direction F1, and the second dimension W401 is a width in a gas direction different from the first direction F1.

For example, as shown in FIG. 6b, both the first dimension W403 and the second dimension W401 may be widths in a same direction. For example, both the first dimension W403 and the second dimension W401 may be widths in a first direction F1.

Further, as shown in FIG. 6a and FIG. 6b, a third dimension W404 exists between side walls of a first groove part 401 that does not surround a second groove part 402, the second groove part 402 has a fourth dimension W402, and the fourth dimension W402 is greater than the third dimension W404. Both the fourth dimension W402 and the third dimension W404 may be widths in a same direction or different directions. For example, both the fourth dimension W402 and the third dimension W404 are widths in the first direction F1. In this way, a size of the second groove part 402 can be increased, to increase a contact area between an electrode metal layer 230 and a first semiconductor layer 211, and further improve uniformity of power supply.

It can be understood that specific values of W401, W402, W403, and W404 may be determined according to a requirement of an actual application scenario. This is not limited herein.

In some embodiments of this application, to set a large size for the second groove part 402, for example, the second groove part 402 is avoided by a semiconductor functional layer 210 around the second groove part 402, to reserve a region for arranging the second groove part 402. For example, in a stacking direction F0, a semiconductor functional layer 210 adjacent to the second groove part 402 has an outer boundary Y210, the second groove part 402 has an outer boundary Y402, and a side, facing the outer boundary Y402, of the outer boundary Y210 has an avoidance recess AC. This is equivalent to forming an avoidance recess AC on a side wall of the semiconductor functional layer 210. In this way, the second groove part 402 can be avoided by using the avoidance recess AC, to increase a size of the second groove part 402. In addition, the avoidance recess AC is provided to avoid the second groove part 402, so that an overall area enclosed by the outer boundary Y210 does not need to be reduced, to avoid excessively reducing an area of the semiconductor functional layer 210. In this way, only a first groove part 401 surrounding the second groove part 402 needs to be expanded around, and a remaining first groove part 401 (especially a first groove part 401 on a grid line) does not need to be expanded. This ensures an area of an active light-emitting region, and further increases a contact area between the electrode metal layer 230 and the first semiconductor layer 211.

Further, a shape of the avoidance recess AC is the same as or similar to a shape at a corresponding position on the outer boundary Y402. Therefore, the shape of the avoidance recess AC may be selected based on the shape at the corresponding position on the outer boundary Y402. Further, the avoidance recess AC is provided on the semiconductor functional layer 210, to better avoid the second groove part 402. For example, a shape of the outer boundary Y402 includes but is not limited to a circular shape, a rectangular shape, a polygonal shape, and the like. For example, if the shape of the outer boundary Y402 is the circular shape, the shape of the avoidance recess AC may be an arc shape. In addition, the size of the second groove part 402 may be greater than, equal to, or less than a size of a second contact hole 332 and a size of a third contact hole 333. This is not limited herein.

Further, a part, extending from the first groove part 401 to the second groove part 402, of the electrode metal layer 230 is in a step shape, to facilitate stress release, reduce a risk of fracture of the electrode metal layer 230, and improve reliability. For example, a first dielectric layer 322 is disposed, to enable a part, extending from the first dielectric layer 322 to a bottom wall of the second groove part 402, of the electrode metal layer 230 to form a step shape. In this application, the first dielectric layer 322 is reused to raise the electrode metal layer 230, so that the electrode metal layer 230 can extend along the first dielectric layer 322 to the bottom wall of the second groove part 402, and the part, extending from the first groove part 401 to the second groove part 402, of the electrode metal layer 230 can form the step shape. Certainly, during actual application, the electrode metal layer 230 may alternatively form a step shape in another manner.

Further, the electrode metal layer 230 may form three steps when extending from the bottom wall of the second groove part 402 to a first surface S1, to further reduce a risk of fracture.

For example, FIG. 6c is another top view of a groove region according to an embodiment of this application. The second groove part 402 may be arranged on at least a part of grid lines in a grid pattern 420. Alternatively, as shown in FIG. 6a, the second groove part 402 may be arranged in at least a part of grid cross regions in the grid pattern 420.

In addition, the structure of the photoelectric device shown in FIG. 6a and FIG. 7 may also be prepared by using the foregoing preparation method. In the step shown in FIG. 5b, the avoidance recess AC is formed. In the step shown in FIG. 5c, a size of the second groove part 402 exposed from the first dielectric layer 322 is made to be large.

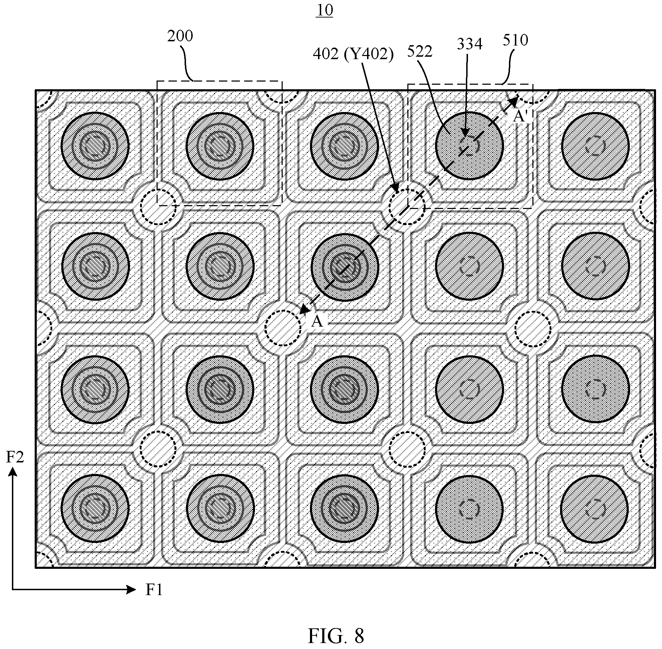

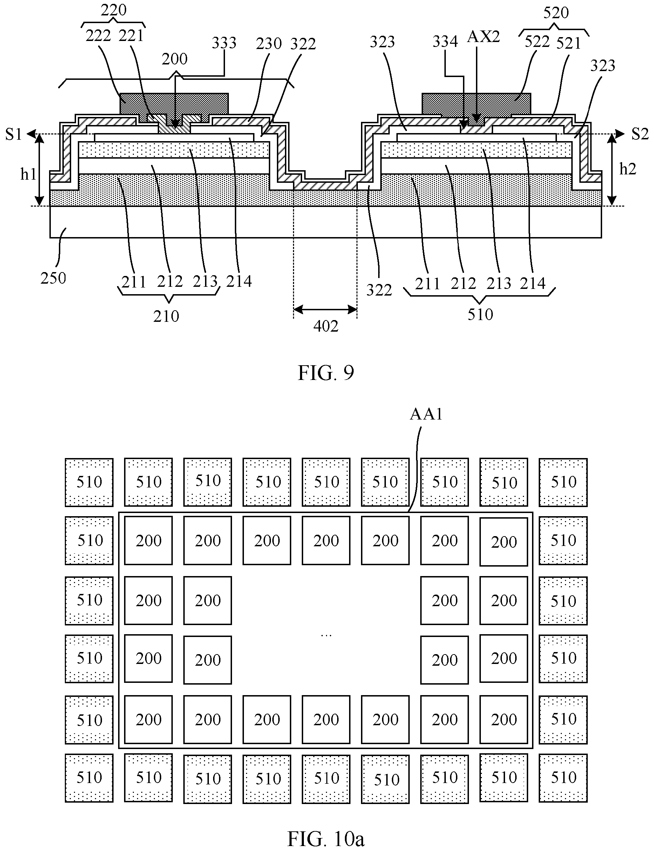

FIG. 8 is a schematic top view of another structure of a photoelectric device according to an embodiment of this application. FIG. 9 is a schematic sectional view of a structure in an AA' direction in FIG. 8. As shown in FIG. 8 and FIG. 9, the photoelectric device in this embodiment is obtained through variation based on the photoelectric device in the foregoing embodiments. A same part between the photoelectric devices is not described herein again. A difference between the photoelectric devices lies in: The photoelectric device 10 not only has a light-emitting pixel 200, but also has one or more boss structures 510. The boss structure 510 has a second surface S2, and a second electrode 520 is disposed on the second surface S2. In this way, the second electrode 520 is raised by using the boss structure 510, and when a first electrode 220 and the second electrode 520 are separately connected to a drive device through interconnection structures, a length difference between an interconnection structure connected to the first electrode 220 and an interconnection structure connected to the second electrode 520 can be minimized, to reduce a risk of a device failure, and improve reliability of interconnection between the photoelectric device 10 and the drive device.

In some embodiments of this application, as shown in FIG. 9, a first vertical distance h1 exists between a first surface S1 and a surface, facing away from the first electrode 220, of a first semiconductor layer 211, and a second vertical distance h2 exists between the second surface S2 and the surface, facing away from the first electrode 220, of the first semiconductor layer 211. A difference between the first vertical distance h1 and the second vertical distance h2 may be set to be less than or equal to a difference threshold, so that the difference between the first vertical distance h1 and the second vertical distance h2 can be minimized or ignored. In this way, a surface on a side, facing away from a substrate 100, of the second electrode 520 and a surface on a side, facing away from the substrate 100, of the first electrode 220 can be formed on a same plane if possible, so that the length difference between the interconnection structure connected to the first electrode 220 and the interconnection structure connected to the second electrode 520 can be minimized, to reduce a risk of a device failure, and improve reliability of interconnection between the photoelectric device 10 and the drive device. It can be understood that the difference between the first vertical distance h1 and the second vertical distance h2 may be a difference value or a ratio between the first vertical distance h1 and the second vertical distance h2. In addition, the difference threshold may be 0±Δh, and Δh may be a difference or an allowed error range that is allowed by a process preparation condition.

In some embodiments of this application, the boss structure 510 is disposed as a multi-layer structure. For example, as shown in FIG. 9, the boss structure 510 may include a semiconductor functional layer 210 and a current extension layer 214. To be specific, the boss structure 510 also includes a first semiconductor layer 211, a light-emitting layer 212, a second semiconductor layer 213, and the current extension layer 214. In this way, the boss structure 510 can also be formed when the semiconductor functional layer 210 and the current extension layer 214 are formed. This not only can minimize the difference between the first vertical distance h1 and the second vertical distance h2, but also can simplify preparation operations of a process. It can be understood that the second surface S2 may be a surface on a side, facing away from the substrate 100, of the current extension layer 214 in the boss structure 510.

As shown in FIG. 8 and FIG. 9, the boss structure 510 is of a structure including the semiconductor functional layer 210 and the current extension layer 214. However, an electrode metal layer 230 is electrically connected to the second electrode 520, and the electrode metal layer 230 is also connected to the first semiconductor layer 211. Therefore, a same voltage is input to both the first semiconductor layer 211 and the second semiconductor layer 213 in the boss structure 510. Consequently, the integrated structure does not emit light. Therefore, a groove region 400 is further arranged between adjacent boss structures 510 and between the boss structure 510 and the light-emitting pixel 200. In addition, to increase an area of the metal electrode layer 230, the metal electrode layer 230 may further cover a side wall of the boss structure. That is, the groove region 400 is arranged between the boss structure 510 and the semiconductor functional layer 210, and the groove region 400 is also arranged between boss structures 510. To be specific, first semiconductor layers 211 in light-emitting pixels 200 form the groove region 400 in an enclosed manner, the first semiconductor layer 211 in the boss structure 510 and a first semiconductor layer 211 in the semiconductor functional layer 210 also form the groove region 400 in an enclosed manner, and first semiconductor layers 211 in boss structures 510 also form the groove region 400 in an enclosed manner.

It should be noted that, if a plurality of boss structures are disposed, the groove region is arranged between the boss structure and the light-emitting pixel, and the groove region is further arranged between boss structures. Alternatively, if one boss structure is disposed, the groove region is arranged between the boss structure and the light-emitting pixel.

For example, the groove structure arranged between the boss structure and the light-emitting pixel may include only a first groove part or a second groove part, or may include both a first groove part and a second groove part. In this way, an area of the electrode metal layer can be further increased, to improve current uniformity of the light-emitting pixel. It can be understood that, for implementations of the first groove part and the second groove part that are arranged between the boss structure and the light-emitting pixel, reference may be made to the descriptions in the foregoing implementations. Details are not described herein again.

For example, the groove structure arranged between the boss structures may include only a first groove part or a second groove part, or may include both a first groove part and a second groove part. In this way, an area of the electrode metal layer can be further increased, to improve current uniformity of the light-emitting pixel. It can be understood that, for implementations of the first groove part and the second groove part that are arranged between the boss structures, reference may be made to the descriptions in the foregoing implementations. Details are not described herein again.

Further, to improve reliability of the electrode metal layer 230, the electrode metal layer 230 and a second dielectric layer 321 also extend to the groove region 400 between the boss structure 510 and the semiconductor functional layer 210, and the electrode metal layer 230 and the second dielectric layer 321 also extend to the groove region 400 between the boss structures 510. In addition, for an implementation of arranging a second groove part 402 in the groove region 400, refer to the arrangement manner of the grid pattern 420 in the foregoing embodiments. For example, the second groove part 402 is arranged in a first cross region 411.

In some embodiments of this application, the boss structure 510 also has an avoidance recess AC on a side of an outer boundary Y402 in a stacking direction F0. For an implementation of the avoidance recess AC, refer to the foregoing embodiments. This is not limited herein. For example, the outer boundary Y402 of the boss structure 510 and an outer boundary Y210 of the semiconductor functional layer 210 may be mirror-symmetric, translationally symmetric, or rotationally symmetric.

Still as shown in FIG. 8 and FIG. 9, the second electrode 520 includes a second electrode connection layer 521 and a second electrode pad layer 522 that are connected to each other, and the second electrode connection layer 521 is disposed between the second electrode pad layer 522 and the boss structure 510. In addition, the second electrode connection layer 521 covers a part or all of regions of the second surface S2, the second electrode connection layer 521 further extends along a side wall of the boss structure 510 to the groove region 400, and the second electrode connection layer 521 is in contact with the electrode metal layer 230. In this way, the second electrode connection layer 521 can be electrically connected to the electrode metal layer 230, and a second voltage is transmitted to the electrode metal layer 230 through the second electrode connection layer 521. In addition, a conductive area can be further increased, to further reduce a voltage drop.

In some embodiments of this application, the second electrode connection layer 521 may be disposed in a manner of covering the side wall of the boss structure 510. For a disposing manner in which the second electrode connection layer 521 covers the side wall of the boss structure 510, refer to the disposing manner in which the electrode metal layer 230 covers the side wall of the semiconductor functional layer 210. Details are not described herein again.

In some embodiments of this application, the second electrode connection layer 521 may cover all regions of the second surface S2, to further increase an area of the second electrode connection layer 521 and reduce a voltage drop of the second electrode connection layer 521. In addition, a surface on a side, facing away from the substrate 100, of the second electrode pad layer 522 may be the surface on the side, facing away from the substrate 100, of the second electrode 520.

To improve adhesion of the second electrode connection layer 521, as shown in FIG. 9, a third dielectric layer 323 is disposed between the second electrode connection layer 521 and the boss structure 510, and the third dielectric layer 323 covers the side wall of the boss structure 510. In addition, the third dielectric layer 323 further extends to the second surface S2 and forms a fourth contact hole 334 on the second surface S2 in an enclosed manner, the second electrode connection layer 521 covers the third dielectric layer 323, and the second electrode connection layer 521 is in contact with the second surface S2 through the fourth contact hole 334. In this way, a second electrode connection layer 521 located on the second surface S2 and a first electrode connection layer 221 located on the first surface S1 can be disposed to be of a same structure if possible. In addition, the second electrode connection layer 521 is in contact with the current extension layer 214 in the boss structure 510, the second voltage is input to the second semiconductor layer 213 in the boss structure 510, and the second voltage is further input to the first semiconductor layer 211 in the boss structure 510, to prevent the light-emitting layer 212 in the boss structure 510 from emitting light.

For example, the third dielectric layer 323 is of a single-layer dielectric thin-film structure or a multi-layer dielectric thin-film composite structure, and a material of the single-layer dielectric thin-film structure and a material of the multi-layer dielectric thin-film composite structure include, but are not limited to, SiO₂, Al₂O₃, MgF₂, TiO₂, Ta₂O₅, ZrO₂, SiN, and the like. In addition, the third dielectric layer 323, a first dielectric layer 322, and the second dielectric layer 321 may be formed by using a same film layer, so that the third dielectric layer 323, the first dielectric layer 322, and the second dielectric layer 321 form an integrated structure. Certainly, during an actual process of preparation, the third dielectric layer 323, the first dielectric layer 322, and the second dielectric layer 321 may alternatively be separately prepared. This is not limited herein.

Further, a material of the electrode metal layer 230 and a material of the second electrode connection layer 521 may be the same or different. For example, as shown in FIG. 9, the electrode metal layer 230 and the second electrode connection layer 521 may be formed by using a same film layer. To be specific, the second electrode connection layer 521 is formed when the electrode metal layer 230 is formed, so that the second electrode connection layer 521 and the electrode metal layer 230 are made of a same material and have a same structure, and the second electrode connection layer 521 and the electrode metal layer 230 form an integrated structure. This not only can reduce process difficulty, but also can increase an area of the electrode metal layer 230 and reduce a voltage drop of the electrode metal layer 230. Certainly, during an actual process of preparation, the second electrode connection layer 521 and the electrode metal layer 230 may alternatively be separately prepared. This is not limited herein.

To reduce difficulty in designing the first electrode pad layer 222 and the second electrode pad layer 522, as shown in FIG. 8 and FIG. 9, a size of the first electrode pad layer 222 and a size of the second electrode pad layer 522 may be set to be the same. Certainly, a size of the first electrode pad layer 222 and a size of the second electrode pad layer 522 may alternatively be set to be different. This is not limited herein. Further, a material of the first electrode pad layer 222 and a material of the second electrode pad layer 522 may be the same or different. For example, the second electrode pad layer 522 is formed when the first electrode pad layer 222 is formed, so that the first electrode pad layer 222 and the second electrode pad layer 522 are made of a same material and have a same structure, to ensure that the surface on the side, facing away from the substrate 100, of the second electrode 520 and the surface on the side, facing away from the substrate 100, of the first electrode 220 are formed on a same plane if possible.

To reduce difficulty in designing the third contact hole 333 and the fourth contact hole 334, as shown in FIG. 8 and FIG. 9, a size of the third contact hole 333 and a size of the fourth contact hole 334 may be set to be the same. Certainly, a size of the third contact hole 333 and a size of the fourth contact hole 334 may alternatively be set to be different. This is not limited herein.

Still as shown in FIG. 8 and FIG. 9, the second electrode pad layer 522 may cover the fourth contact hole 334. Alternatively, because the second electrode connection layer 521 covers the boss structure 510, the second electrode pad layer 522 may be disposed in the fourth contact hole 334. This is not limited herein.

Further, as shown in FIG. 9, a profile of the second electrode connection layer 521 in the stacking direction F0 has a second groove AX2, and the second groove AX2 is filled with a partial region of the second electrode pad layer 522. In this way, the partial region of the second electrode pad layer 522 is embedded in the second groove AX2 to form a step-shaped pad, to improve reliability.

As shown in FIG. 8, when the boss structure 510 is disposed in the photoelectric device, a proportion of the first groove part 401 in the groove region 400, a proportion of the second groove part 402 in the groove region 400, a percentage of a coverage area of the electrode metal layer 230 in a total area of the entire photoelectric device, a proportion of an area of a first electrode metal layer 230 part in a total area of the electrode metal layer 230, and a proportion of an area of a second electrode metal layer 230 part in the total area of the electrode metal layer 230 may also meet a numerical relationship in the foregoing embodiments. Details are not described herein again.

In addition, a shape of the fourth contact hole 334 is not limited in this application. For example, the shape of the fourth contact hole 334 includes but is not limited to a circular shape, a rectangular shape, a polygonal shape, and the like. Further, the shape of the fourth contact hole 334 and a shape of the third contact hole 333 may be the same or different. In addition, a size of the fourth contact hole 334 and a size of the third contact hole 333 may be the same or different.

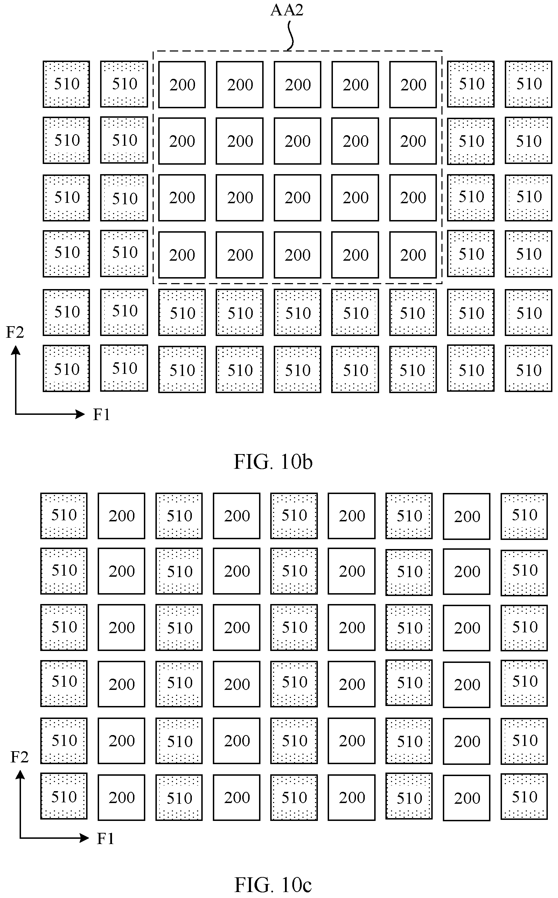

In this application, light-emitting pixels 200 and boss structures 510 are arranged in an array, to improve uniformity of electric conduction. In some examples, all of the light-emitting pixels 200 may be surrounded by the boss structures 510. For example, FIG. 10a shows an arrangement manner of light-emitting pixels and boss structures according to an embodiment of this application. The boss structures 510 form an enclosed region AA1, and all of the light-emitting pixels 200 are disposed in the enclosed region AA1. In addition, the boss structures 510 surrounding all of the light-emitting pixels 200 may be boss structures 510 arranged in one circle, boss structures 510 arranged in two circles, or boss structures 510 arranged in more circles. Alternatively, a part of the light-emitting pixels 200 may be surrounded by the boss structures 510. For example, FIG. 10b shows another arrangement manner of light-emitting pixels and boss structures according to an embodiment of this application. The boss structures 510 form a semi-enclosed region AA2, and all of the light-emitting pixels 200 are disposed in the semi-enclosed region AA2. Certainly, the boss structures 510 may alternatively be disposed on two sides of the light-emitting pixels 200 in a second direction F2 or a first direction F1. This is not limited herein.

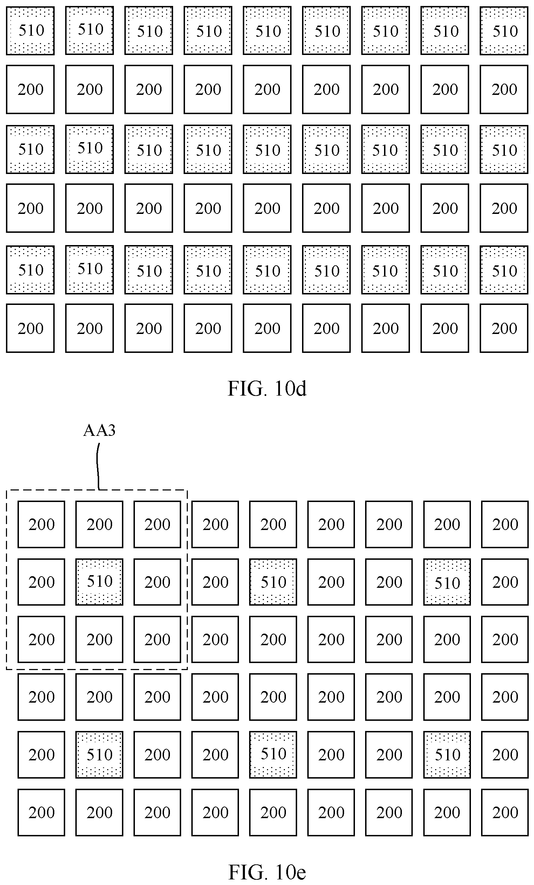

In some other examples, the light-emitting pixels 200 and the boss structure 510 may alternatively appear alternately based on a specific periodicity and ratio, to improve uniformity of electric conduction. For example, FIG. 10c shows another arrangement manner of light-emitting pixels and boss structures according to an embodiment of this application. A plurality of light-emitting pixels 200 form a column of light-emitting pixels 200 in a second direction F2, a plurality of boss structures 510 form a column of boss structures 510 in the second direction F2, and one column of light-emitting pixels 200 and one column of boss structures 510 are alternately arranged in a first direction F1, or a plurality of adjacent columns of light-emitting pixels 200 and a plurality of adjacent columns of boss structures 510 are alternately arranged in a first direction F1. Alternatively, FIG. 10d shows another arrangement manner of light-emitting pixels and boss structures according to an embodiment of this application. A plurality of light-emitting pixels 200 form a row of light-emitting pixels 200 in a first direction F1, a plurality of boss structures 510 form a row of boss structures 510 in the first direction F1, and one row of light-emitting pixels 200 and one row of boss structures 510 are alternately arranged in a second direction F2, or a plurality of adjacent rows of light-emitting pixels 200 and a plurality of adjacent rows of boss structures 510 are alternately arranged in a second direction F2. Alternatively, for example, FIG. 10e shows another arrangement manner of light-emitting pixels and boss structures according to an embodiment of this application. The boss structures 510 include a plurality of repeatedly arranged structural units AA3, each structural unit AA3 includes light-emitting pixels 200 and a boss structure 510, and in a same structural unit AA3, light-emitting pixels 200 surround all boss structures 510. This not only can implement an electrical connection, but also can reduce a quantity of boss structures 510 that do not emit light, and increase a quantity of boss structures 510 that emit light. Certainly, in a same structural unit AA3, boss structures 510 may alternatively surround all or a part of light-emitting pixels 200.

It should be noted that FIG. 10a to FIG. 10e merely show some example arrangement manners of the light-emitting pixels 200 and the boss structures 510, and other arrangement manners of the light-emitting pixels 200 and the boss structures 510 are not exhaustively listed herein.

Preparation of the structure of the photoelectric device shown in FIG. 8 and FIG. 9 is used as an example. A preparation method for a photoelectric device according to an embodiment of this application may include the following content.

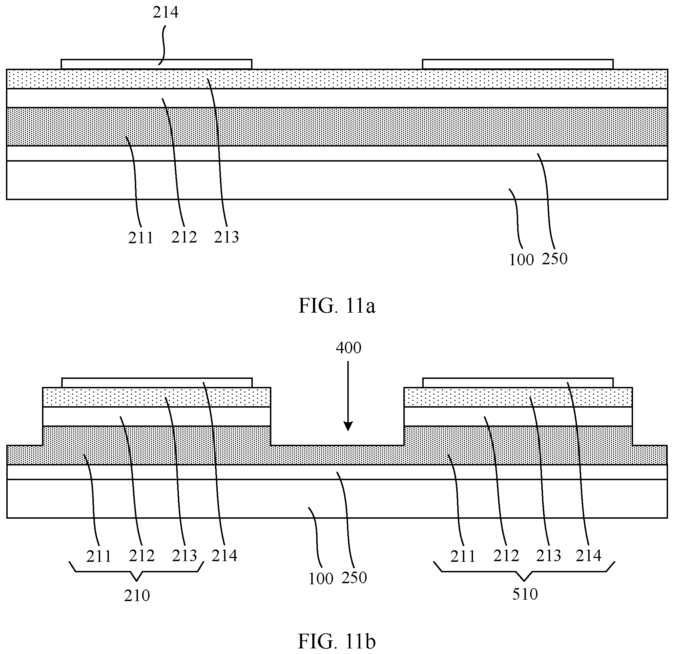

FIG. 11a is a schematic sectional view of a structure of a photoelectric device during preparation according to an embodiment of this application. For example, a substrate 100 is provided. The substrate 100 includes, for example, but is not limited to, a Si substrate 100, a SiC substrate 100, a sapphire substrate 100, or a GaN substrate 100. A buffer layer 250, a first semiconductor layer 211, a light-emitting layer 212, and a second semiconductor layer 213 are sequentially epitaxially formed on the substrate 100. Then a current extension layer 214 is formed through deposition.

FIG. 11b is a schematic sectional view of another structure of a photoelectric device during preparation according to an embodiment of this application. For example, the first semiconductor layer 211, the light-emitting layer 212, and the second semiconductor layer 213 are patterned through a patterning process to form a groove region 400 in the first semiconductor layer 211. The light-emitting layer 212 is formed on a side, facing away from the substrate 100, of a protruding part of the first semiconductor layer 211, and the second semiconductor layer 213 is formed on a side, facing away from the substrate 100, of the light-emitting layer 212. In this way, a first semiconductor layer 211, a light-emitting layer 212, and a second semiconductor layer 213 in a semiconductor functional layer 210 are formed, and a first semiconductor layer 211, a light-emitting layer 212, a second semiconductor layer 213, and a current extension layer 214 in a boss structure 510 are formed.

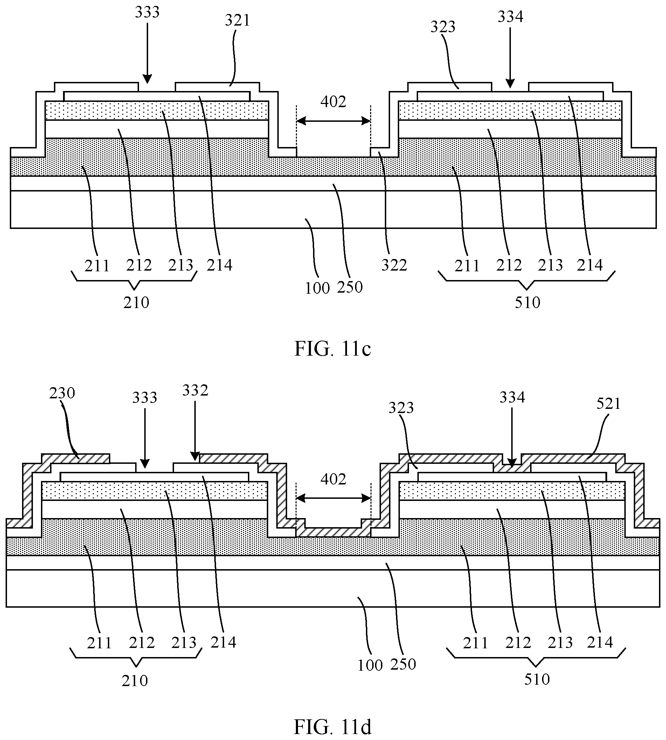

FIG. 11c is a schematic sectional view of another structure of a photoelectric device during preparation according to an embodiment of this application. For example, a dielectric layer is formed through deposition on a side, facing away from the substrate 100, of the current extension layer 214, and the dielectric layer includes a first dielectric layer 322, a second dielectric layer 321, and a third dielectric layer 323. Then the dielectric layer is patterned through a patterning process, to expose a second groove part 402 and form a third contact hole 333 and a fourth contact hole 334.

FIG. 11d is a schematic sectional view of another structure of a photoelectric device during preparation according to an embodiment of this application. For example, a metal material is deposited on a side, facing away from the substrate 100, of the dielectric layer to form an electrode metal layer 230 and a second electrode connection layer 521, the electrode metal layer 230 is in contact with the first semiconductor layer 211 through the second groove part 402, and the second electrode connection layer 521 is in contact with the current extension layer 214 in the boss structure 510 through the fourth contact hole 334. Then the electrode metal layer 230 is patterned through a patterning process to form a second contact hole 332 that passes through the electrode metal layer 230.

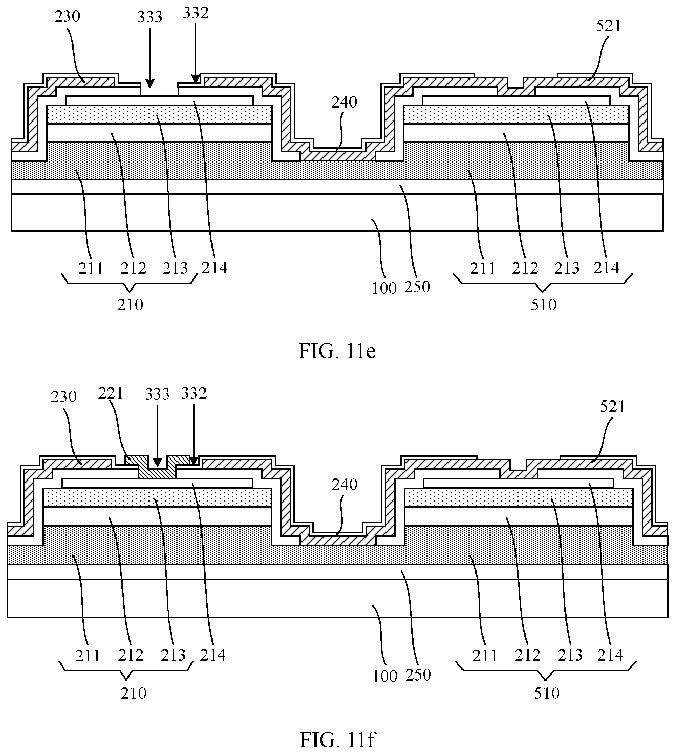

FIG. 11e is a schematic sectional view of another structure of a photoelectric device during preparation according to an embodiment of this application. For example, a passivation layer 240 is formed through deposition on a side, facing away from the substrate 100, of the metal layer, and the third contact hole 333 and a partial region of the second electrode connection layer 521 on a second surface are exposed.

FIG. 11f is a schematic sectional view of another structure of a photoelectric device during preparation according to an embodiment of this application. For example, a first electrode connection layer 221 is formed through deposition on a side, facing away from the substrate 100, of the passivation layer 240, and the first electrode connection layer 221 is in contact with the current extension layer 214 on the semiconductor functional layer 210.

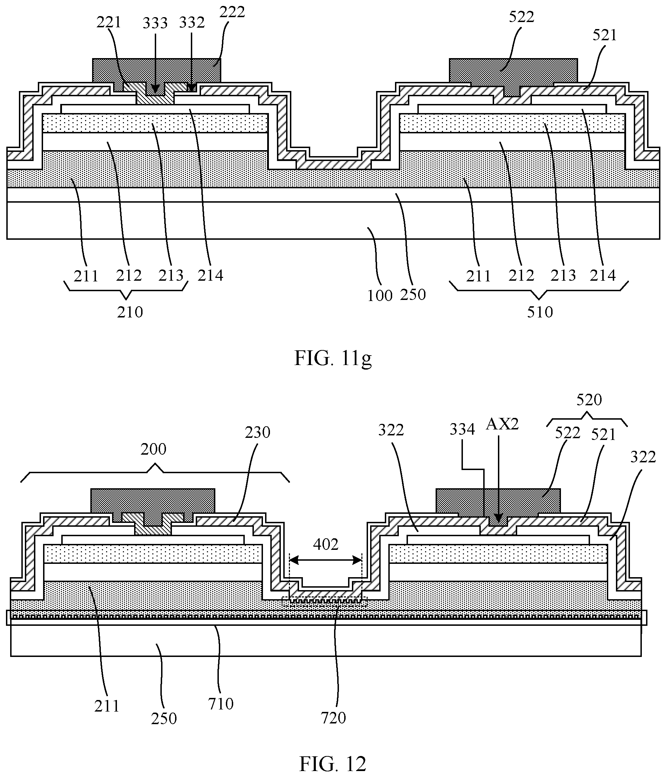

As shown in FIG. 11g, a first electrode pad layer 222 and a second electrode pad layer 522 are formed, the first electrode pad layer 222 is connected to the first electrode connection layer 221, and the second electrode pad layer 522 is connected to the second electrode connection layer 521.

FIG. 12 is a schematic sectional view of another structure in an AA' direction in FIG. 8. As shown in FIG. 12, the photoelectric device in this embodiment is obtained through variation based on the photoelectric device in the foregoing embodiments. A same part between the photoelectric devices is not described herein again. A difference between the photoelectric devices lies in: A plurality of first protrusion structures 710 are disposed between the buffer layer 250 and the first semiconductor layer 211, and the plurality of first protrusion structures 710 are disposed at spacings. In this way, a surface on a side, facing the buffer layer 250, of the first semiconductor layer 211 is roughened, to change an included angle between emergent light and a boundary surface, reduce occurrences of total reflection, improve light output efficiency, and prevent light from being refracted back and forth in a light-emitting element. For example, the plurality of first protrusion structures 710 and the buffer layer 250 may be disposed as an integrated structure. For example, the plurality of first protrusion structures 710 extend from the buffer layer 250 toward the first semiconductor layer 211, so that the first semiconductor layer 211 can be more tightly bound to the buffer layer 250. Alternatively, the plurality of first protrusion structures 710 may be independent of the buffer layer 250. For example, the first protrusion structures 710 may be arranged in an array, to evenly improve light output efficiency. Further, a height of the first protrusion structure 710 is less than a thickness of the buffer layer 250 and a thickness of the first semiconductor layer 211. For example, the height of the first protrusion structure 710 may range from 0.5 µm to 3 µm. For example, the height of the first protrusion structure 710 is 0.5 µm, 1 µm, 1.5 µm, 2 µm, 2.5 µm, or 3 µm. During actual application, the shape of the first protrusion structure 710 may be a cone, a cylinder, a pyramid, or a prism. This is not limited in this application. In addition, the structure of the photoelectric device 10 shown in FIG. 12 may also be prepared by using the foregoing preparation method. After the buffer layer 250 is formed, a surface of the buffer layer 250 may be processed through a patterning process, a texturing process, or a roughening process to form the plurality of first protrusion structures 710. Alternatively, a plurality of first protrusion structures 710 that are independent of the buffer layer 250 may be formed on a surface of the buffer layer 250 through a patterning process, a texturing process, or a roughening process.

Further, a first semiconductor layer 211 located on a bottom wall of the second groove part 402 may have a plurality of second protrusion structures 720, and the plurality of second protrusion structures 720 are disposed at spacings. The plurality of first protrusion structures 710 extend from the first semiconductor layer 211 toward the electrode metal layer 230, so that the first semiconductor layer 211 can be more tightly bound to the electrode metal layer 230, and light reflected by the electrode metal layer 230 can exit more evenly. In addition, for an implementation of the second protrusion structure 720, refer to the implementation of the first protrusion structure 710. Details are not described herein again. It can be understood that a first semiconductor layer 211 located on a bottom wall of a first groove part 401 may also have a plurality of second protrusion structures 720, to improve bonding.

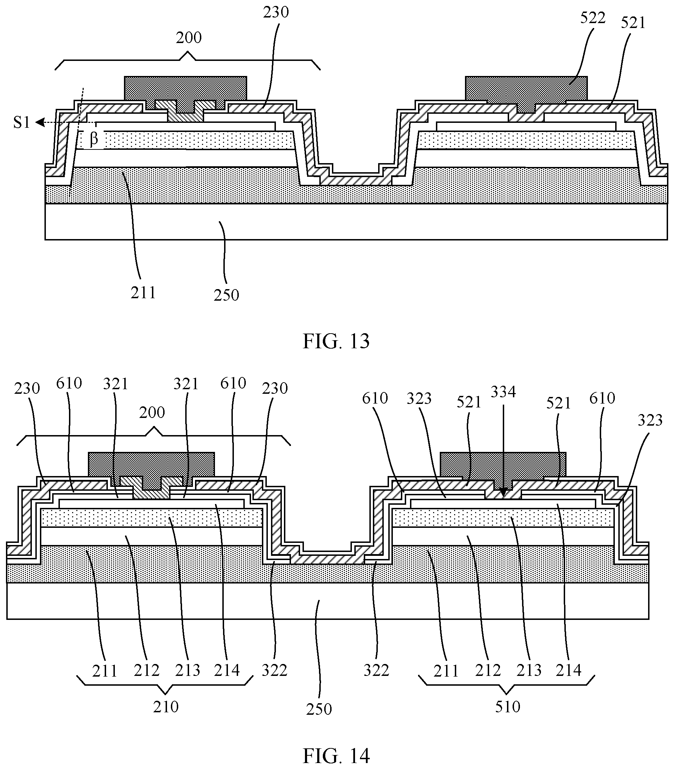

FIG. 13 is a schematic sectional view of another structure in an AA' direction in FIG. 8. As shown in FIG. 13, the photoelectric device in this embodiment is obtained through variation based on the photoelectric device in the foregoing embodiments. A same part between the photoelectric devices is not described herein again. A difference between the photoelectric devices lies in: There is an included angle β between a side wall of a semiconductor functional layer 210 and a first surface S1, the included angle β faces a side of the semiconductor functional layer 210, and the included angle β is set to an obtuse angle. In this way, the side wall of the semiconductor functional layer 210 may be disposed in a tilting manner, to further reduce stress formed by an electrode metal layer 230, and further reduce a risk of fracture of the electrode metal layer 230.

FIG. 14 is a schematic sectional view of another structure in an AA' direction in FIG. 8. As shown in FIG. 14, the photoelectric device in this embodiment is obtained through variation based on the photoelectric device in the foregoing embodiments. A same part between the photoelectric devices is not described herein again. A difference between the photoelectric devices lies in: A light-emitting pixel 200 further includes a distributed Bragg reflection layer 610, and the distributed Bragg reflection layer 610 is disposed between a second dielectric layer 321 and an electrode metal layer 230, to further improve reflection efficiency. In some embodiments of this application, the distributed Bragg reflection layer 610 further covers one or more of the following dielectric layers: a second dielectric layer 321, a first dielectric layer 322, and a third dielectric layer 323. In this way, when the electrode metal layer 230 is a metal layer, light first passes through the distributed Bragg reflection layer 610, then enters the electrode metal layer 230, then is reflected by the electrode metal layer 230 and enters the distributed Bragg reflection layer 610, and finally is reflected from a side of the distributed Bragg reflection layer 610. This can address insufficient reflection bandwidth of the distributed Bragg reflection layer 610 through the electrode metal layer 230, and can also address low light-emitting efficiency caused by absorbing a part of light by the metal layer. It can be understood that the distributed Bragg reflection layer 610 forms a distributed Bragg reflector mirror (distributed Bragg reflector mirror, DBR) structure.

In some other embodiments of this application, as shown in FIG. 14, a second groove part 402, a third contact hole 333, and a fourth contact hole 334 may be exposed from the distributed Bragg reflection layer 610. In other words, the distributed Bragg reflection layer 610 may be further disposed between the first dielectric layer 322 and the electrode metal layer 230 through extension. Further, the distributed Bragg reflection layer 610 may be disposed between the third dielectric layer 322 and a second electrode connection layer 521 through extension, and the distributed Bragg reflection layer 610 extends to the fourth contact hole 334.

In addition, the distributed Bragg reflection layer 610 includes a plurality of first refractive index layers and a plurality of second refractive index layers, and the first refractive index layers and the second refractive index layers are alternately disposed. The first refractive index layer or the second refractive index layer is in contact with the second dielectric layer 321. In addition, a refractive index of a first refractive index layer is greater than a refractive index of a second refractive index layer adjacent to the first refractive index layer. During specific implementation, a quantity of first refractive index layers is the same as a quantity of second refractive index layers, and a specific quantity may be determined according to a requirement of an actual application scenario. Further, refractive indexes of all the first refractive index layers are the same, and thicknesses of all the first refractive index layers are the same. In addition, refractive indexes of all the second refractive index layers are the same, and thicknesses of all the second refractive index layers are the same. Certainly, thicknesses of different first refractive index layers may alternatively be different, and thicknesses of different second refractive index layers may alternatively be different. This is not limited herein. In addition, the structure of the photoelectric device shown in FIG. 14 may also be prepared by using the foregoing preparation method, and a step of preparing the distributed Bragg reflection layer is added between FIG. 11c and FIG. 11d.

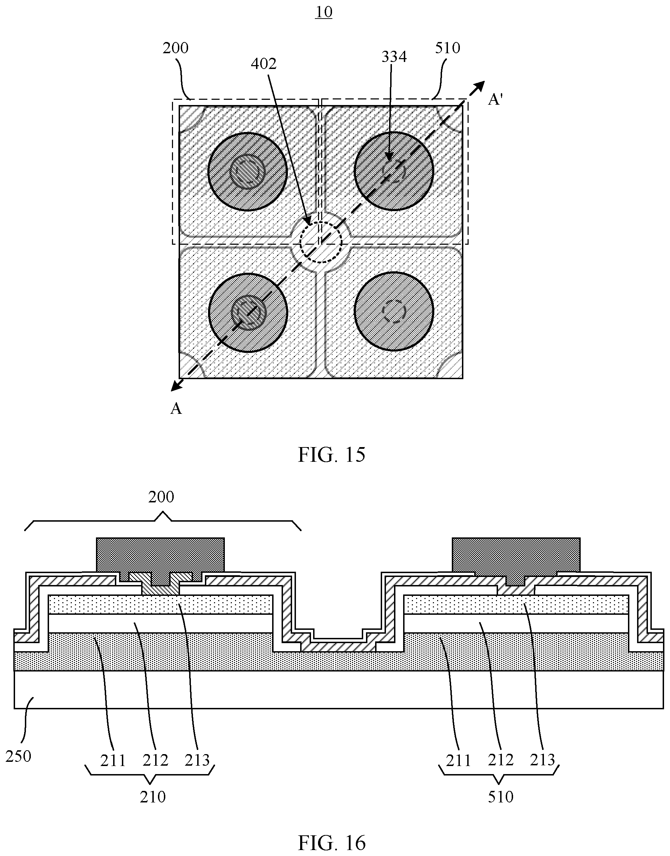

FIG. 15 is a schematic top view of another structure of a photoelectric device according to an embodiment of this application. FIG. 16 is a schematic sectional view of another structure in an AA' direction in FIG. 15. As shown in FIG. 15 and FIG. 16, the photoelectric device in this embodiment is obtained through variation based on the photoelectric device in the foregoing embodiments. A same part between the photoelectric devices is not described herein again. A difference between the photoelectric devices lies in: A light-emitting pixel includes a semiconductor functional layer 210, and does not include a current extension layer 214. In this case, a surface on a side, facing away from a light-emitting layer 212, of a second semiconductor layer 213 in the semiconductor functional layer 210 may be set as a first surface S1, and a first electrode connection layer 221 is in direct contact with the second semiconductor layer 213 in the light-emitting pixel 200, to implement an electrical connection between the first electrode connection layer 221 and the second semiconductor layer 213 in the light-emitting pixel 200. In some embodiments of this application, if a boss structure 510 is disposed in the photoelectric device and the boss structure 510 is of a structure same as a structure of the semiconductor functional layer 210, a surface on a side, facing away from the light-emitting layer 212, of a second semiconductor layer 213 in the boss structure 510 may be set as a second surface S2. In this case, a second electrode connection layer 521 is in direct contact with the second semiconductor layer 213 in the boss structure 510. In addition, the structure of the photoelectric device 10 shown in FIG. 15 and FIG. 16 may also be prepared by using the foregoing preparation method, and the step shown in FIG. 5b is directly omitted.

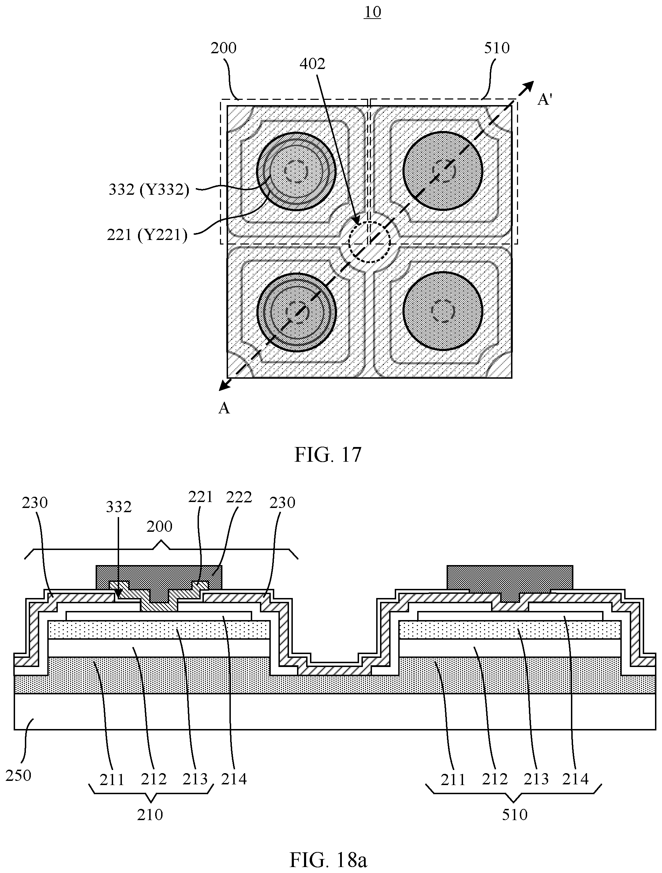

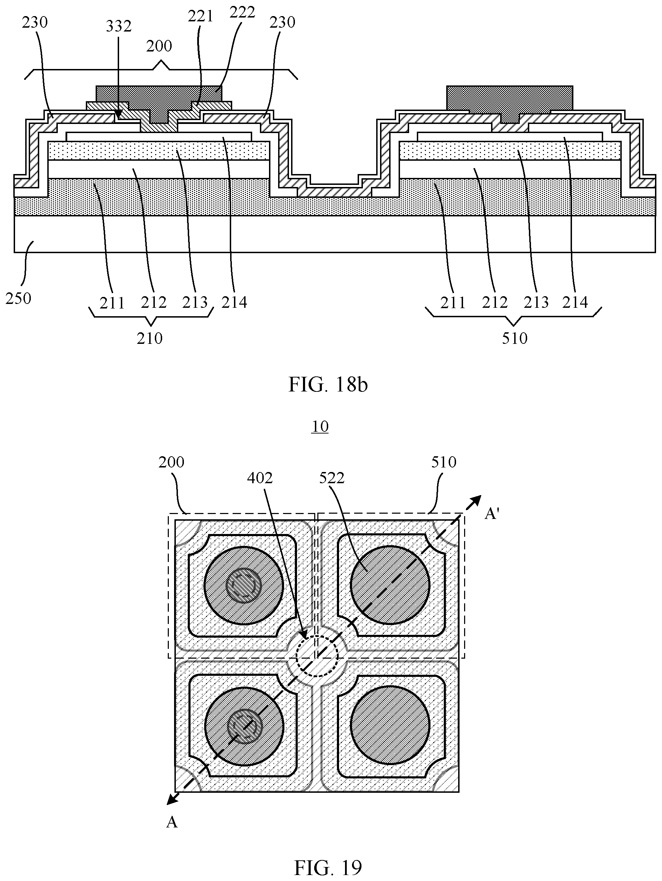

FIG. 17 is a schematic top view of another structure of a photoelectric device according to an embodiment of this application. FIG. 18a is a schematic sectional view of a structure in an AA' direction in FIG. 17. FIG. 18b is a schematic sectional view of another structure in an AA' direction in FIG. 17. As shown in FIG. 17 to FIG. 18b, the photoelectric device in this embodiment is obtained through variation based on the photoelectric device in the foregoing embodiments. A same part between the photoelectric devices is not described herein again. A difference between the photoelectric devices lies in: An outer boundary Y221 covers an outer boundary Y332. To be specific, a first electrode connection layer 221 extends from a bottom wall of a third contact hole 333 along a side wall of the third contact hole 333 to a side wall of a second contact hole 332, and the first electrode connection layer 221 further extends along a side wall of a second contact hole 332 to a periphery of an opening of the second contact hole 332. A passivation layer 240 is disposed between the first electrode connection layer 221 and an electrode metal layer 230. In addition, the periphery of the opening of the second contact hole 332 is a small part of an edge of the opening of the second contact hole 332.

As shown in FIG. 18a, in a stacking direction F0, a first electrode pad layer 222 may cover the first electrode connection layer 221. Alternatively, as shown in FIG. 18b, in a stacking direction F0, the first electrode connection layer 221 may alternatively cover a first electrode pad layer 222.

In addition, the structure of the photoelectric device 10 shown in FIG. 17 and FIG. 18a may also be prepared by using the foregoing preparation method.

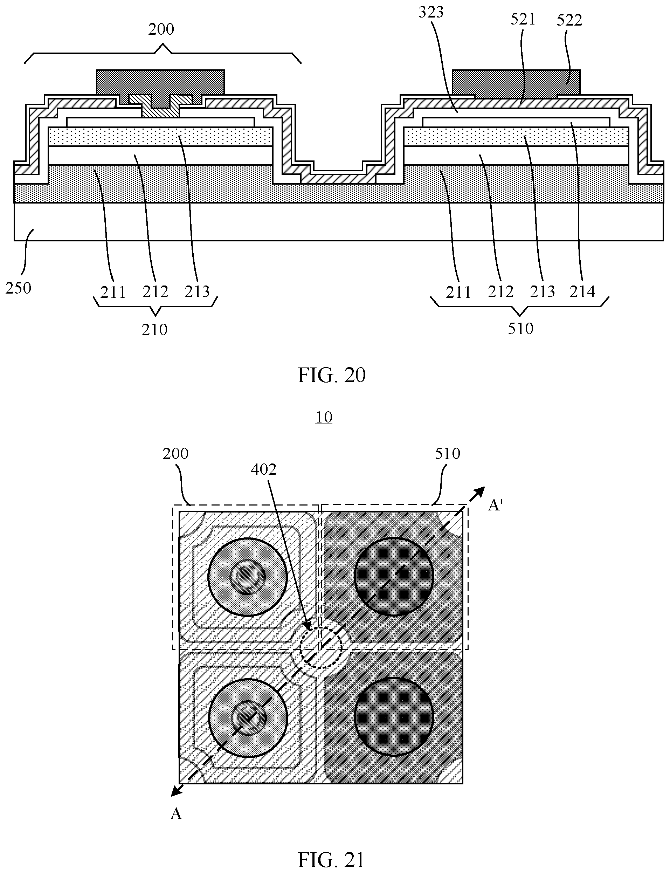

FIG. 19 is a schematic top view of another structure of a photoelectric device according to an embodiment of this application. FIG. 20 is a schematic sectional view of a structure in an AA' direction in FIG. 19. As shown in FIG. 19 and FIG. 20, the photoelectric device in this embodiment is obtained through variation based on the photoelectric device in the foregoing embodiments. A same part between the photoelectric devices is not described herein again. A difference between the photoelectric devices lies in: A third dielectric layer 323 covers a second surface S2 of a boss structure 510. To be specific, no fourth contact hole 334 is provided. In addition, a second electrode connection layer 521 covers the third dielectric layer 323, and the second electrode connection layer 521 is insulated from the boss structure 510. Further, an orthographic projection of a passivation layer 240 on a substrate 100 also covers an orthographic projection of the boss structure 510 on the substrate 100. In addition, the structure of the photoelectric device 10 shown in FIG. 19 and FIG. 20 may also be prepared by using the foregoing preparation method.

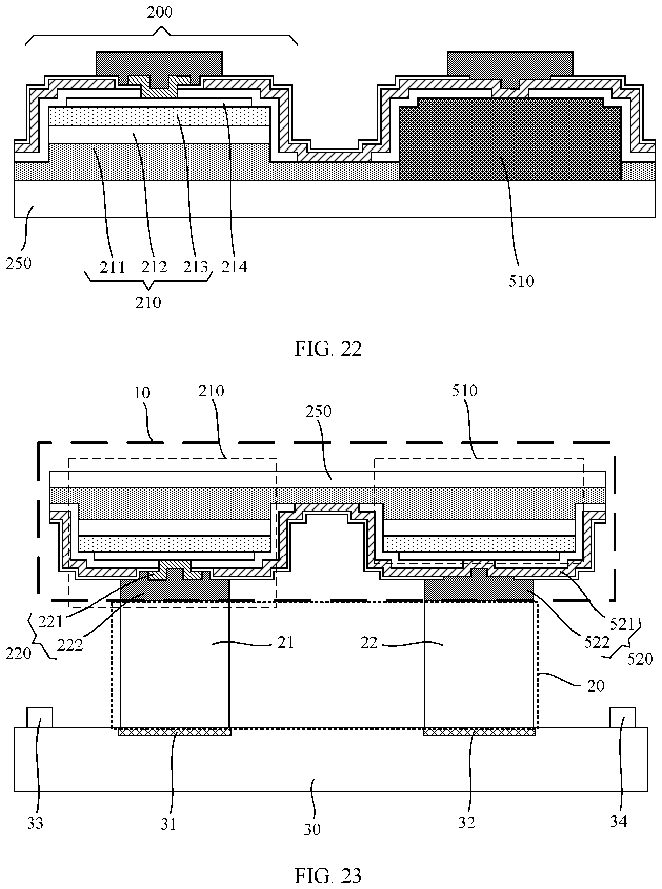

FIG. 21 is a schematic top view of another structure of a photoelectric device according to an embodiment of this application. FIG. 22 is a schematic sectional view of a structure in an AA' direction in FIG. 21. As shown in FIG. 22 and FIG. 21, the photoelectric device in this embodiment is obtained through variation based on the photoelectric device in the foregoing embodiments. A same part between the photoelectric devices is not described herein again. A difference between the photoelectric devices lies in: A boss structure 510 and a semiconductor functional layer 210 are of different structures. For example, the boss structure 510 is of a single-layer structure, and the boss structure 510 includes one of a semiconductor material layer, an insulation material layer, or a metal material layer. Alternatively, the boss structure 510 is of a multi-layer structure, and the boss structure 510 includes a combination of two or all of a semiconductor material layer, an insulation material layer, or a metal material layer. In addition, a material of the semiconductor material layer, the insulation material layer, or the metal material layer may be a material mentioned in this application, or may be another material. This is not limited herein. Further, to improve reliability of an electrode metal layer 230, a first semiconductor layer 211 may extend to a gap between the boss structure 510 and the semiconductor functional layer 210, so that the first semiconductor layer 211, the boss structure 510, and the semiconductor functional layer 210 form a groove region 400 in an enclosed manner. In addition, the first semiconductor layer 211 extends to a gap between adjacent boss structures 510, so that the first semiconductor layer 211 and the adjacent boss structures 510 form a groove region 400 in an enclosed manner. In addition, for a manner of disposing the electrode metal layer 230 in the groove region 400, refer to the disposing manner in the foregoing embodiments. Details are not described herein again. In addition, the structure of the photoelectric device 10 shown in FIG. 21 and FIG. 22 may also be prepared by using the foregoing preparation method, and a boss structure 510 of a structure different from a structure of the semiconductor functional layer 210 is formed.

Based on this, an embodiment of this application further provides a light-emitting module. FIG. 23 is a diagram of a structure of a light-emitting module according to an embodiment of this application. The light-emitting module includes a photoelectric device 10, a drive device 30, and an interconnection assembly 20. The interconnection assembly 20 is located between the photoelectric device 10 and the drive device 30, and the drive device 30 is located on a side, with a plurality of light-emitting pixels 200, of the photoelectric device 10. The drive device 30 includes a first drive pad 31 and a second drive pad 32 that face a side of the photoelectric device 10. The interconnection assembly 20 includes a first interconnection structure 21 and a second interconnection structure 22 that are disposed at a spacing. A first end of the first interconnection structure 21 is connected to a first electrode pad layer 222 in a first electrode 220, and a second end of the first interconnection structure 21 is connected to the first drive pad 31. A first end of the second interconnection structure 22 is connected to a second electrode pad layer 522 in a second electrode 520, and a second end of the second interconnection structure 22 is connected to the second drive pad 32.

Specifically, the drive device 30 may separately output corresponding voltages to the first drive pad 31 and the second drive pad 32. In addition, a quantity of first drive pads 31 is the same as a quantity of light-emitting pixels 200 in a one-to-one correspondence, and a quantity of second drive pads 32 is the same as a quantity of boss structures 510 in a one-to-one correspondence. In addition, the drive device 30 further includes a plurality of third drive pads (for example, 33 and 34) connected to a circuit board 2. The plurality of third drive pads (for example, 33 and 34) may include a power supply electrode pad, a ground electrode pad, a drive electrode pad for transmitting a drive signal, and the like. For example, the drive device 30 may be disposed as a drive chip. Alternatively, the drive device 30 may alternatively be a drive substrate on which a plurality of pixel circuits and a common electrode are disposed, the plurality of pixel circuits are connected to the first drive pads 31 in a one-to-one correspondence and output corresponding voltages to the first drive pads 31, and the second drive pad 32 is connected to the common electrode.

In addition, a quantity of first interconnection structures 21 is the same as a quantity of light-emitting pixels 200 in a one-to-one correspondence, and a quantity of second interconnection structures 22 is the same as a quantity of boss structures 510 in a one-to-one correspondence. In addition, each first interconnection structure 21 and each second interconnection structure 22 are disposed at a spacing. In addition, a first end of a first interconnection structure 21 is connected to a corresponding first electrode pad layer 222 in the first electrode 220, and a second end of the first interconnection structure 21 is connected to a corresponding first drive pad 31, so that the drive device outputs a first voltage to the first electrode 220 through the first drive pad 31 and the first interconnection structure 21. In addition, a first end of a second interconnection structure 22 is connected to a corresponding second electrode pad layer 522 in the second electrode 520, and a second end of the second interconnection structure 22 is connected to a second drive pad 32, so that the drive device outputs a second voltage to the second electrode 520 through the second drive pad 32 and the second interconnection structure 22. For example, the first interconnection structure 21 and the second interconnection structure 22 each may be a metal interconnection structure. The metal interconnection structure is, for example, a bump (bump). The bump (bump) includes a micro bump (Micro bump), a copper pillar bump (Copper pillar bump, CPB), or the like. In addition, a material of the first interconnection structure 21 and a material of the second interconnection structure 22 each include one or more of Au, Cu, Ni, Ag, and Sn. The material of the first interconnection structure 21 and the material of the second interconnection structure 22 each include at least one bonding metal layer (for example, Sn, SnAg, or AuSn). In addition, the first interconnection structure 21 and the second interconnection structure 22 are of a same structure.

In addition, in this application, the second electrode 520 is connected to an electrode metal layer, so that the second voltage transmitted by the second electrode 520 can be input to a first semiconductor layer 211 of the light-emitting pixel 200. A second semiconductor layer 213 of the light-emitting pixel 200 is connected to the first electrode 220 through a current extension layer 214, and the first voltage transmitted by the first electrode 220 is input to the second semiconductor layer 213, to drive a light-emitting layer 212 to emit light. Therefore, in addition to the second electrode 520 formed on a second surface S2 of the boss structure 510, the electrode metal layer 230 connected to a first semiconductor layer 211 of each light-emitting pixel 200 is further formed in a groove region 400, and therefore no electrode for connecting to the first semiconductor layer 211 needs to be additionally formed in the light-emitting pixel 200. In this way, interconnection between the drive device 30 and the photoelectric device 10 is implemented by preparing only first interconnection structures 21 whose quantity is the same as the quantity of light-emitting pixels 200 and second interconnection structures 22 whose quantity is the same as the quantity of boss structures 510, to reduce interconnection point positions and reduce process difficulty.

In addition, in the photoelectric device 10 in this application, a difference between a first vertical distance h1 and a second vertical distance h2 is less than or equal to a difference threshold, so that the difference between the first vertical distance h1 and the second vertical distance h2 is minimized. In this way, the second electrode 520 and the first electrode 220 can be formed on a same plane if possible, so that a difference between a length of the first interconnection structure 21 and a length of the second interconnection structure 22 can be minimized, to reduce a risk of a device failure, and improve reliability of interconnection between the photoelectric device 10 and the drive device.

As shown in FIG. 23, a surface on a side, facing away from the interconnection assembly 20, of the buffer layer 250 may be further roughened, to change an included angle between emergent light and a boundary surface, reduce occurrences of total reflection, improve light output efficiency, and prevent light from being refracted back and forth in a light-emitting element.

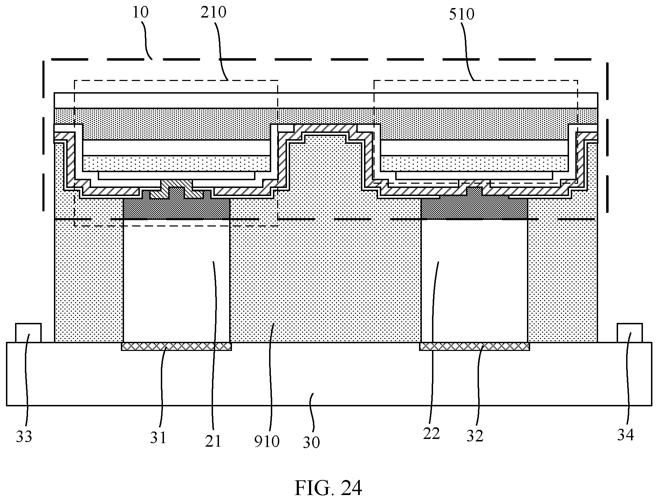

FIG. 24 is a diagram of another structure of a light-emitting module according to an embodiment of this application. As shown in FIG. 24, a photoelectric device in this embodiment is obtained through variation based on the photoelectric device in the foregoing embodiments. A same part between the photoelectric devices is not described herein again. A difference between the photoelectric devices lies in: An underfill structure layer 910 is further disposed between the photoelectric device 10 and a drive device 30. To be specific, an interconnection assembly 20 is disposed in the underfill structure layer 910, and the photoelectric device 10, the interconnection assembly 20, and the drive device 30 are protected by the underfill structure layer 910, to further improve reliability of the light-emitting module 1 and avoid damage caused by stress. For example, a material of the underfill structure layer 910 includes a polymer material and a filling particle. The polymer material includes, for example, but is not limited to, resin. The filling material includes, for example, but is not limited to, SiO₂ and TiO₂. During specific implementation, physical performance of the material of the underfill structure layer 910 may be adjusted based on different particle sizes and mixing ratios.

In some examples, the structure of the light-emitting module shown in FIG. 24 is used as an example. A preparation method for a light-emitting module according to an embodiment of this application may include the following content: A photoelectric device 10 and a drive device 30 are separately prepared. Then a first interconnection structure 21 and a second interconnection structure 22 are prepared on a side of the drive device 30 or the photoelectric device 10, or a first interconnection structure 21 and a second interconnection structure 22 are prepared on both a side of the drive device 30 and a side of the photoelectric device 10. Then the photoelectric device 10 is electrically connected to the drive device 30 through the first interconnection structure 21 and the second interconnection structure 22 by using a thermal compression bonding process, a reflow soldering process, or a direct bond interconnect (Direct bond interconnect, DBI) process. Then an underfill material is applied between the photoelectric device 10 and the drive device 30 to form an underfill structure layer 910. Then a substrate 100 carrying the photoelectric device 10 is removed, or a substrate 100 carrying the photoelectric device 10 may be thinned, or an opening may be provided in a region, corresponding to a light-emitting pixel 200, on a substrate 100 carrying the photoelectric device 10. Further, after the substrate 100 carrying the photoelectric device 10 is removed, an optical conversion layer may be further prepared on a surface on a side, facing away from the drive device, of a buffer layer 250. The optical conversion layer includes but is not limited to a fluorescent conversion layer (for example, one or a combination of a red fluorescent conversion layer, a green fluorescent conversion layer, and a blue fluorescent conversion layer) or a quantum dot conversion layer (for example, one or a combination of a red quantum dot conversion layer, a green quantum dot conversion layer, and a blue quantum dot conversion layer).

In some other examples, the structure of the light-emitting module shown in FIG. 24 is used as an example. A preparation method for a light-emitting module according to an embodiment of this application may include the following content: A photoelectric device 10 and a drive device are separately prepared. Then a first interconnection structure 21 and a second interconnection structure 22 are prepared on a side of the drive device or the photoelectric device 10, or a first interconnection structure 21 and a second interconnection structure 22 are prepared on both a side of the drive device and a side of the photoelectric device 10. Then an underfill film is attached to a surface of the drive device or the photoelectric device 10. Then the photoelectric device 10 is electrically connected to the drive device through the first interconnection structure 21 and the second interconnection structure 22 by using a thermal compression bonding process, a reflow soldering process, or a direct bond interconnect (Direct bond interconnect, DBI) process. Then a substrate 100 carrying the photoelectric device 10 is removed, or a substrate 100 carrying the photoelectric device 10 may be thinned, or an opening may be provided in a region, corresponding to a light-emitting pixel 200, on a substrate 100 carrying the photoelectric device 10. Further, after the substrate 100 carrying the photoelectric device 10 is removed, an optical conversion layer may be further prepared on a surface on a side, facing away from the drive device, of a buffer layer 250. The optical conversion layer includes but is not limited to a fluorescent conversion layer (for example, one or a combination of a red fluorescent conversion layer, a green fluorescent conversion layer, and a blue fluorescent conversion layer) or a quantum dot conversion layer (for example, one or a combination of a red quantum dot conversion layer, a green quantum dot conversion layer, and a blue quantum dot conversion layer).

Based on the content described in Embodiment 1, an embodiment of this application further provides another photoelectric device. The following provides specific descriptions with reference to Embodiment 2.

### Embodiment 2:

Usually, light generated by a light-emitting layer of a light-emitting pixel is randomly transmitted to all directions, where a part of light exits from a light exit surface of the light-emitting pixel, and a part of light exits from a non-light-exit surface of the light-emitting pixel. If the light on the non-light-exit surface cannot be effectively used, energy loss occurs, and light output efficiency of a light-emitting array is also reduced. In view of this, an embodiment of this application provides a photoelectric device. A reflection area can be effectively increased by disposing a first reflection layer and a second reflection layer, so that light transmitted by a light-emitting pixel to a non-light-exit surface can be reflected to a light exit surface as much as possible, to improve light output efficiency of the device.

The following describes in detail the photoelectric device provided in this embodiment of this application with reference to the accompanying drawings.

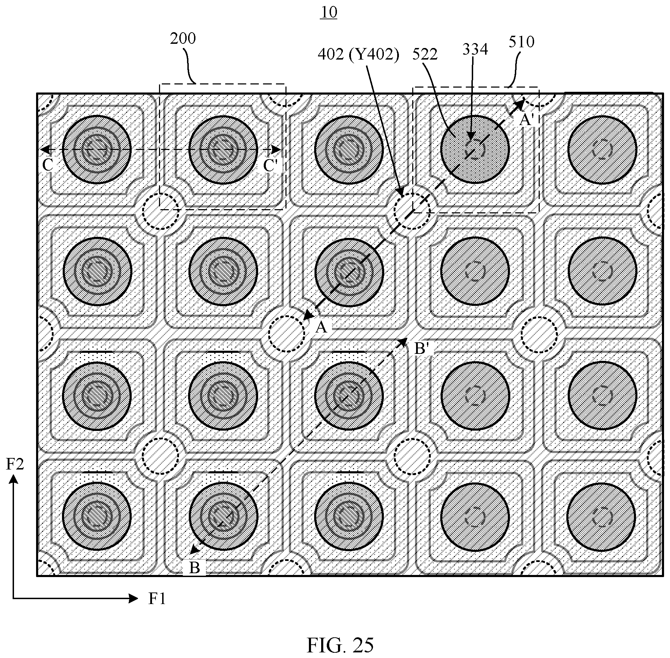

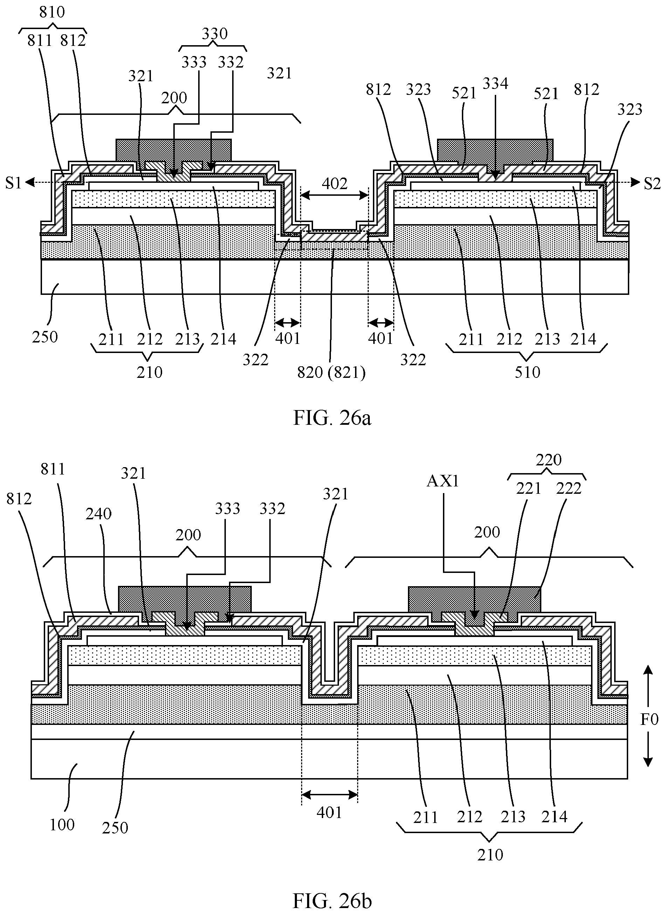

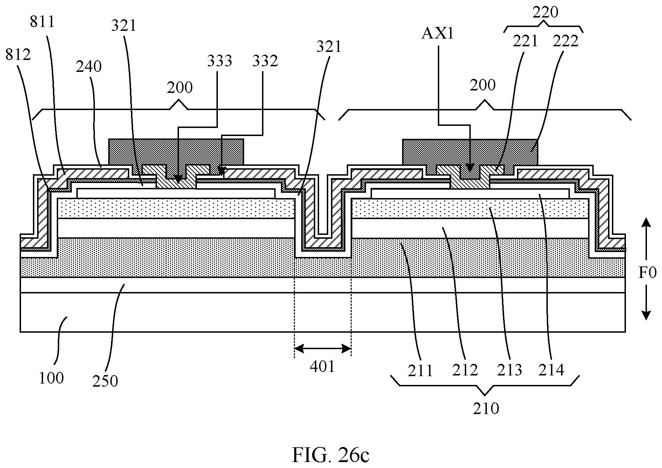

FIG. 25 is a schematic top view of another structure of a photoelectric device according to an embodiment of this application. FIG. 26a is a schematic sectional view of a structure in an AA' direction in FIG. 25. FIG. 26b is a schematic sectional view of a structure in a BB' direction in FIG. 25. FIG. 26c is a schematic sectional view of a structure in a CC' direction in FIG. 25. As shown in FIG. 25 to FIG. 26c, the photoelectric device 10 includes a plurality of light-emitting pixels 200, a groove region 400, and a first reflection layer. Each light-emitting pixel 200 includes a semiconductor functional layer 210 and a first electrode 220. Each semiconductor functional layer 210 includes a first semiconductor layer 211, a light-emitting layer 212, and a second semiconductor layer 213 that are disposed in a stacked manner. In addition, the first reflection layer 810 covers at least a partial region of each light-emitting pixel, and further covers at least a partial region of the groove region. In addition, the first electrode 220 is insulated from the first reflection layer 810, so that the first electrode 220 inputs a first voltage to the second semiconductor layer 213. In this way, the first reflection layer 810 reflects, to a light exit surface as much as possible, light transmitted by the semiconductor functional layer 210 toward a side wall of the first reflection layer 810 and the first electrode 220, to improve light output efficiency of the device.

As shown in FIG. 26a to FIG. 26c, the groove region 400 is formed on the semiconductor functional layer 210, and the groove region 400 may be used to isolate the plurality of light-emitting pixels 200 from each other. The groove region 400 may include a first groove part 401 and a second groove part 402, and the first reflection layer 810 further covers at least a partial region of the first groove part 401. In this way, the first reflection layer 810 can further reflect, to the light exit surface as much as possible, light that enters the first groove part 401, to improve light output efficiency of the device.

For example, the first reflection layer 810 may cover all regions of a bottom wall of the first groove part 401, or the first reflection layer 810 may cover a partial region of a bottom wall of the first groove part 401. This is not limited herein.

As shown in FIG. 26a to FIG. 26c, a second reflection layer 820 is further included, and the second reflection layer 820 covers at least a partial region of the second groove part 402. In this way, the second reflection layer 820 can reflect, to the light exit surface as much as possible, light that enters the second groove part 402, to improve light output efficiency of the device.

For example, the second reflection layer 820 may cover all regions of a bottom wall of the second groove part 402, or the second reflection layer 820 may cover a partial region of a bottom wall of the second groove part 402. This is not limited herein.

For example, the first groove part 401 is located between adjacent light-emitting pixels 200, and the first groove part 401 further surrounds the second groove part 402 and is in communication with the second groove part 402. In this way, an electrode metal layer 230 can extend in the first groove part 401 and the second groove part 402. It can be understood that, for implementations of the first groove part 401 and the second groove part 402 in this embodiment, reference may be made to the implementations of the first groove part 401 and the second groove part 402 in the foregoing embodiments. Details are not described herein again.

In addition, the first reflection layer 810 covers a side wall of the semiconductor functional layer 210, and the first reflection layer 810 further extends along the side wall of the semiconductor functional layer 210 to a side, facing the first electrode 220, of the semiconductor functional layer 210. The first reflection layer 810 further forms a contact through-hole 330 in an enclosed manner on a side, facing the first electrode 220, of the semiconductor functional layer 210. The first electrode 220 is electrically connected to the second semiconductor layer 213 through the contact through-hole 330.

In some embodiments of this application, a proportion of the first groove part 401 in the groove region 400, a proportion of the second groove part 402 in the groove region 400, a percentage of a coverage area of the electrode metal layer 230 in a total area of the entire photoelectric device, a proportion of an area of a first electrode metal layer 230 part in a total area of the electrode metal layer 230, and a proportion of an area of a second electrode metal layer 230 part in the total area of the electrode metal layer 230 may also meet a numerical relationship in the foregoing embodiments. Details are not described herein again.

As shown in FIG. 26a to FIG. 26c, the first reflection layer 810 may include a first metal layer 811 and a distributed Bragg reflection layer 812 that are disposed in a stacked manner. The distributed Bragg reflection layer 812 is disposed between the first metal layer 811 and the semiconductor functional layer 210. In this way, light first passes through the distributed Bragg reflection layer 812, then enters the first metal layer 811, then is reflected by the first metal layer 811 and enters the distributed Bragg reflection layer 812, and finally is reflected from a side of the distributed Bragg reflection layer 812. This can address insufficient reflection bandwidth of the distributed Bragg reflection layer 812 through the first metal layer 811, and can also address low light-emitting efficiency caused by absorbing a part of light by the metal layer. It can be understood that the distributed Bragg reflection layer 812 forms a distributed Bragg reflector mirror (distributed Bragg reflector mirror, DBR) structure.

It can be understood that, for an implementation of the first metal layer 811 in this embodiment, reference may be made to the implementation of the electrode metal layer 230 in the foregoing embodiments. Details are not described herein again. In addition, for an implementation of the distributed Bragg reflection layer in this embodiment, refer to the implementation of the distributed Bragg reflection layer in the foregoing embodiments. Details are not described herein again.

In some embodiments of this application, as shown in FIG. 25 to FIG. 26c, the contact through-hole 330 includes a second contact hole 332 and a third contact hole 333. The first metal layer 811 extends to cover a first surface S1, and forms the second contact hole 332 on the first surface S1 in an enclosed manner. The distributed Bragg reflection layer 812 extends to cover the first surface S1, and forms the third contact hole 333 on an inner side of the second contact hole 332 in an enclosed manner. It can be understood that, for implementations of the second contact hole 332 and the third contact hole 333, reference may be made to the implementations of the second contact hole 332 and the third contact hole 333 in the foregoing embodiments. Details are not described herein again.

In some embodiments of this application, as shown in FIG. 26a to FIG. 26c, the light-emitting pixel 200 further includes a second dielectric layer 321. The second dielectric layer 321 is located between the distributed Bragg reflection layer 812 and the semiconductor functional layer 210. The second dielectric layer 321 covers a side wall of the semiconductor functional layer 210, and the second dielectric layer 321 further extends along the side wall of the semiconductor functional layer 210 to the third contact hole 333. It can be understood that, for implementations of the second dielectric layer 321 and the third contact hole 333, reference may be made to the implementations of the second dielectric layer 321 and the third contact hole 333 in the foregoing embodiments. Details are not described herein again.

In some embodiments of this application, as shown in FIG. 26a to FIG. 26c, a first dielectric layer 322 is disposed between the first reflection layer 810 and the bottom wall of the first groove part 401. It can be understood that, for an implementation of the first dielectric layer 322 in this embodiment, reference may be made to the implementation of the first dielectric layer 322 in the foregoing embodiments. Details are not described herein again.

In some embodiments of this application, as shown in FIG. 26a to FIG. 26c, the second reflection layer 820 includes a second metal layer 821, and the first metal layer 811 and the second metal layer 821 are connected to each other. It can be understood that, for an implementation of the second metal layer 821, reference may be made to the implementation of the electrode metal layer 230 in the second groove part 402 in the foregoing embodiments. Details are not described herein again.

In some embodiments of this application, as shown in FIG. 26a, a part, extending along the first dielectric layer 322 to the bottom wall of the second groove part 402, of the first metal layer 811 is in a step shape. It can be understood that, for an implementation of the step shape, reference may be made to the implementation of the step shape in the foregoing embodiments. Details are not described herein again.

In some embodiments of this application, as shown in FIG. 26a to FIG. 26c, the second metal layer 821 and the first metal layer 811 are formed by using a same film layer.

In some embodiments of this application, as shown in FIG. 26a to FIG. 26c, the groove region 400 is of a grid pattern, and the second groove part 402 is arranged in at least a part of grid cross regions in the grid pattern, or the second groove part 402 is arranged on at least a part of grid lines in the grid pattern. It can be understood that, for an implementation of the second groove part 402 in the grid pattern, reference may be made to the implementation of the second groove part 402 in the grid pattern 420 in the foregoing embodiments. Details are not described herein again.

In some embodiments of this application, as shown in FIG. 26a to FIG. 26c, the semiconductor functional layer 210 further includes a current extension layer 214, and the current extension layer 214 is disposed on the second semiconductor layer 213. The current extension layer 214 may be a transparent conducting layer, and an average value of refractive indexes of the current extension layer 214 and the second dielectric layer 321 is less than a refractive index of the first semiconductor layer 211 and a refractive index of the second semiconductor layer 213. It can be understood that, for an implementation of the current extension layer 214, reference may be made to the implementation of the current extension layer 214 in the foregoing embodiments. Details are not described herein again.

In some embodiments of this application, as shown in FIG. 26a to FIG. 26c, a part, extending from the side wall of the semiconductor functional layer 210 to the first surface S1, of the first metal layer 811 is in a double-step shape.

In some embodiments of this application, a surface, facing away from the light-emitting layer, of the second semiconductor layer has a first region and a second region. The first region surrounds the second region. The current extension layer 214 covers the second region. The second dielectric layer 321 further covers the first region. The electrode metal layer 230 further covers a second dielectric layer 321 located in the first region. It can be understood that, for this implementation, reference may be made to the implementations in the foregoing embodiments. Details are not described herein again.

In some embodiments of this application, as shown in FIG. 26a to FIG. 26c, the first electrode 220 includes a first electrode connection layer 221 and a first electrode pad layer 222 that are connected to each other. The first electrode connection layer 221 is disposed between the first electrode pad layer 222 and the semiconductor functional layer 210. The first electrode connection layer 221 is connected to the second semiconductor layer 213 through the second contact hole 332 and the third contact hole 333.

In some embodiments of this application, in a stacking direction of the light-emitting layer and the second semiconductor layer, a spacing between an outer boundary of the first electrode connection layer and an outer boundary of the second contact hole is greater than 0. In the stacking direction of the light-emitting layer and the second semiconductor layer, the first electrode connection layer covers the second contact hole; or in the stacking direction of the light-emitting layer and the second semiconductor layer, the first electrode connection layer is disposed in the second contact hole. It can be understood that, for implementations of the outer boundary of the first electrode connection layer and the outer boundary of the second contact hole, reference may be made to the implementations of the outer boundary of the first electrode connection layer and the outer boundary of the second contact hole in the foregoing embodiments. Details are not described herein again.

In some embodiments of this application, as shown in FIG. 26a to FIG. 26c, the first electrode pad layer 222 covers the second contact hole 332, and a passivation layer is disposed between the first electrode pad layer 222 and the electrode metal layer 230.

In some embodiments of this application, as shown in FIG. 26a to FIG. 26c, a profile of the first electrode connection layer 221 in the stacking direction F0 has a first groove AX1, the first groove AX1 is filled with a partial region of the first electrode pad layer 222, and the stacking direction F0 is perpendicular to a plane on which a substrate 100 is located.

It can be understood that, for implementations of the first electrode connection layer 221 and the first electrode pad layer 222 in this embodiment, reference may be made to the implementations of the first electrode connection layer 221 and the first electrode pad layer 222 in the foregoing embodiments. Details are not described herein again.

In some embodiments of this application, as shown in FIG. 25 and FIG. 26a, the photoelectric device further includes one or more boss structures 510 and a second electrode 520. The boss structure 510 and the light-emitting pixel 200 are disposed at a spacing. The boss structure 510 has a second surface S2. The second electrode 520 is disposed on the second surface S2, and the second electrode 520 is connected to the first metal layer 811 and the second metal layer 821.

In some embodiments of this application, as shown in FIG. 25 and FIG. 26a, the second electrode 520 includes a second electrode connection layer 521 and a second electrode pad layer 522 that are connected to each other, and the second electrode connection layer 521 is disposed between the second electrode pad layer 522 and the boss structure 510. In addition, the second electrode connection layer 521 covers at least a partial region of the second surface S2, and the second electrode connection layer 521 further covers at least a partial side wall of the boss structure 510.

In some embodiments of this application, as shown in FIG. 25 and FIG. 26a, the second electrode connection layer 521 covers all side walls of the boss structure 510.

In some embodiments of this application, as shown in FIG. 25 and FIG. 26a, the second electrode connection layer 521 covers all regions of the second surface S2.

In some embodiments of this application, as shown in FIG. 25 and FIG. 26a, a third dielectric layer 323 is disposed between the second electrode connection layer 521 and the boss structure 510. The third dielectric layer 323 covers a side wall of the boss structure 510. The third dielectric layer 323 further extends to the second surface S2, and forms a fourth contact hole 334 on the second surface S2 in an enclosed manner. The second electrode connection layer 521 is in contact with the second surface S2 through the fourth contact hole 334.

In some embodiments of this application, as shown in FIG. 25 and FIG. 26a, the second electrode pad layer 522 covers the fourth contact hole 334.

In some embodiments of this application, as shown in FIG. 25 and FIG. 26a, a profile of the second electrode connection layer 521 in the stacking direction F0 has a second groove AX2, and the second groove AX2 is filled with a partial region of the second electrode pad layer 522.

In some embodiments of this application, as shown in FIG. 25 and FIG. 26a, a third dielectric layer 323 is disposed between the second electrode connection layer 521 and the boss structure 510, the third dielectric layer 323 covers a side wall of the boss structure 510, and the second dielectric layer 321 further covers the second surface S2.

In some embodiments of this application, as shown in FIG. 25 and FIG. 26a, the second electrode connection layer 521 and the first metal layer 811 are formed by using a same film layer.

In some embodiments of this application, as shown in FIG. 25 and FIG. 26a, the first dielectric layer 322, the second dielectric layer 321, and the third dielectric layer are formed by using a same film layer.

In some embodiments of this application, the boss structure 510 is of a single-layer structure, and the boss structure 510 includes one of a semiconductor material layer, an insulation material layer, or a metal material layer.

In some embodiments of this application, the boss structure 510 is of a multi-layer structure, and the boss structure 510 includes a combination of a semiconductor material layer, an insulation material layer, or a metal material layer.

In some embodiments of this application, as shown in FIG. 25 and FIG. 26a, the boss structure 510 is of a multi-layer structure, and the boss structure includes a semiconductor functional layer, or the boss structure includes a semiconductor functional layer and a current extension layer 214 disposed on the semiconductor functional layer.

It can be understood that, for implementations of the boss structure 510 and the second electrode 520 in this embodiment, reference may be made to the implementations of the boss structure 510 and the second electrode 520 in the foregoing embodiments. Details are not described herein again.

Based on this, an embodiment of this application further provides a light-emitting module. As shown in FIG. 23 and FIG. 24, the light-emitting module includes a photoelectric device 10, a drive device 30, and an interconnection assembly 20. The drive device 30 is located on a side, with a plurality of light-emitting pixels, of the photoelectric device 10, and the drive device 30 includes a first drive pad 31. The interconnection assembly 20 is located between the photoelectric device 10 and the drive device 30, and the interconnection assembly 20 includes a first interconnection structure 21. In addition, a first end of the first interconnection structure 21 is connected to a first electrode 220, and a second end of the first interconnection structure 21 is connected to the first drive pad 31.

In some embodiments of this application, as shown in FIG. 25 to FIG. 26c, the photoelectric device 10 further includes a boss structure 510 and a second electrode 520 that are located on a substrate 100, the drive device 30 further includes a second drive pad 32, and the interconnection assembly 20 further includes a second interconnection structure 22. In addition, a first end of the second interconnection structure 22 is connected to the second electrode 520, and a second end of the second interconnection structure 22 is connected to the second drive pad 32.

It can be understood that, for a preparation method for the photoelectric device in this embodiment, reference may also be made to the preparation method in the foregoing embodiments. Details are not described herein again.

It should be noted that the implementations in Embodiment 2 may alternatively not rely on the implementations in Embodiment 1, and may alternatively be other implementations. This is not specifically limited herein.

Based on the content described in Embodiment 1 and Embodiment 2, an embodiment of this application further provides another photoelectric device. The following provides specific descriptions with reference to Embodiment 3.

### Embodiment 3:

Usually, a voltage needs to be input to a light-emitting pixel through a contact electrode. If transition performed by the contact electrode between two planes is insufficiently smooth, the contact electrode is likely to break, causing a failure of some light-emitting pixels. In view of this, an embodiment of this application provides a photoelectric device. An electrode metal layer 230 is disposed. The electrode metal layer 230 extends to the contact electrode and is connected to the contact electrode, and a part, extending to the contact electrode, of the electrode metal layer 230 is in a step shape, to reduce a risk of fracture of the electrode metal layer 230, and improve reliability. In addition, the electrode metal layer 230 is connected to the contact electrode, so that a conductive area of the contact electrode can be further increased, to reduce a voltage drop of the contact electrode and enable the contact electrode to withstand a larger current.

The following describes in detail a photoelectric device provided in embodiments of this application with reference to the accompanying drawings.

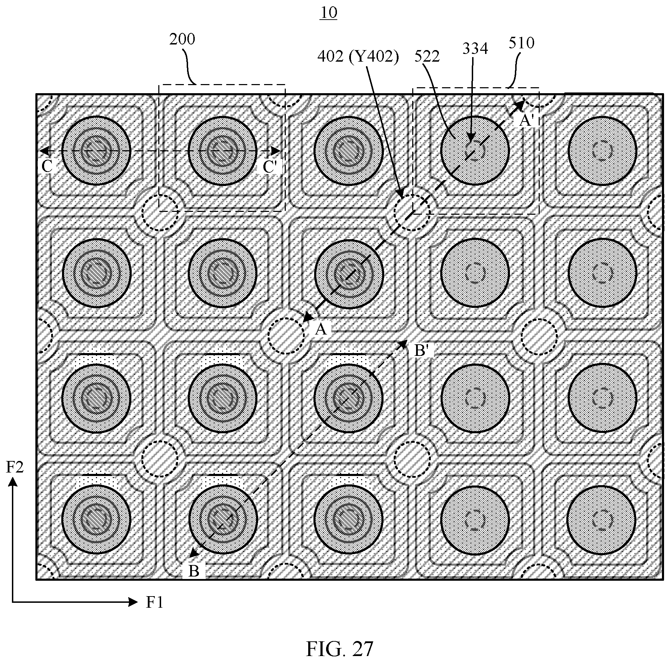

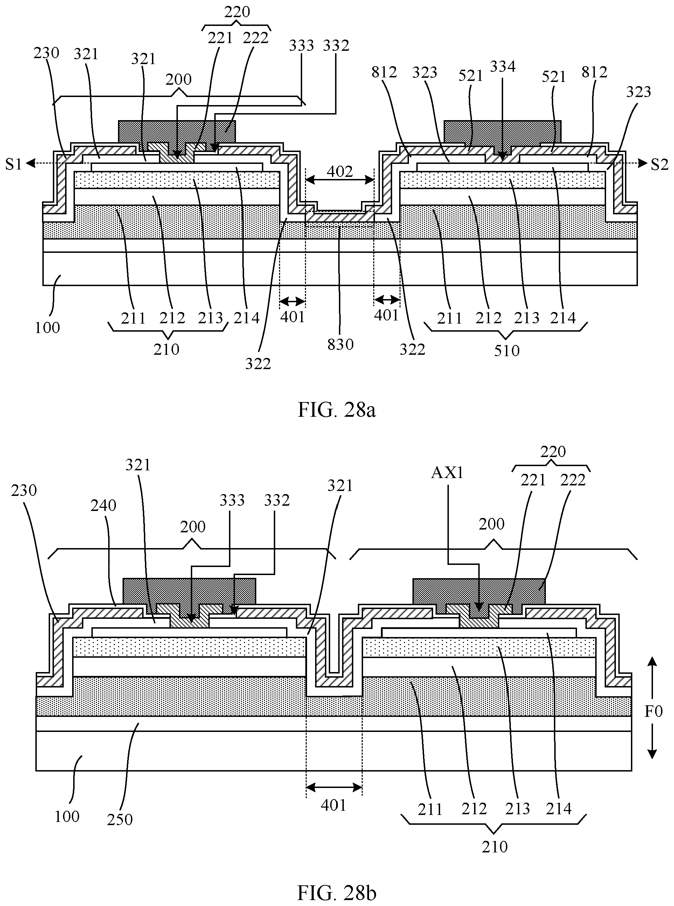

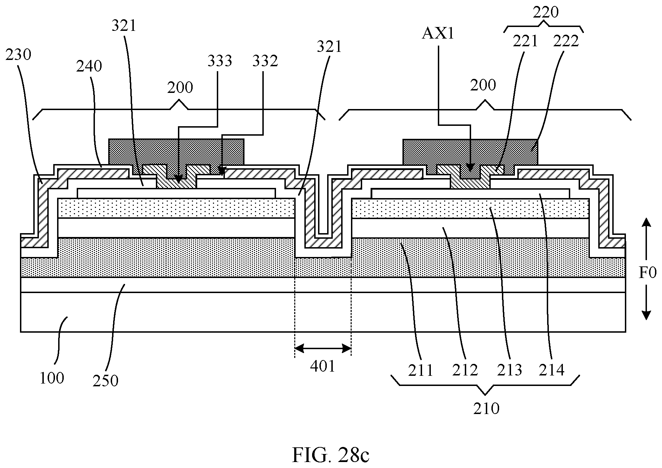

FIG. 27 is a schematic top view of another structure of a photoelectric device according to an embodiment of this application. FIG. 28a is a schematic sectional view of a structure in an AA' direction in FIG. 27. FIG. 28b is a schematic sectional view of a structure in a BB' direction in FIG. 27. FIG. 28c is a schematic sectional view of a structure in a CC' direction in FIG. 27. As shown in FIG. 27 to FIG. 28c, the photoelectric device 10 includes a plurality of light-emitting pixels 200, a groove region 400, and an electrode metal layer 230. Each light-emitting pixel 200 includes a semiconductor functional layer 210 and a first electrode 220. Each semiconductor functional layer 210 includes a first semiconductor layer 211, a light-emitting layer 212, and a second semiconductor layer 213 that are disposed in a stacked manner. The second semiconductor layer 213 is electrically connected to the first electrode 220. The electrode metal layer 230 is electrically connected to a second electrode.

In addition, the groove region 400 is formed on the semiconductor functional layer 210, and the groove region 400 may be used to isolate the plurality of light-emitting pixels 200 from each other. The groove region 400 may include a first groove part 401 and a second groove part 402, and the electrode metal layer 230 covers at least a partial surface of each light-emitting pixel 200, at least a partial region of the first groove part 401, and at least a partial region of the second groove part 402. In addition, the electrode metal layer 230 is insulated from the semiconductor functional layer in the first groove part 401, and the electrode metal layer 230 is electrically connected to the first semiconductor layer 211 in the second groove part 402. In addition, a first dielectric layer 322 is disposed between the electrode metal layer 230 and a bottom wall of the first groove part 401. In addition, a part, extending from the first dielectric layer 322 to a bottom wall of the second groove part 402, of the electrode metal layer 230 is in a step shape, to reduce a risk of fracture of the electrode metal layer 230, and improve reliability.

It can be understood that, for implementations of the first dielectric layer 322 and the electrode metal layer 230 in this embodiment, reference may be made to the implementations of the first dielectric layer 322 and the electrode metal layer 230 in the foregoing embodiments. Details are not described herein again. In addition, for an implementation of the contact electrode 830 in this embodiment, reference may be made to the implementation of the second metal layer 821 in the foregoing embodiments. Details are not described herein again.

In some embodiments of this application, as shown in FIG. 27 to FIG. 28c, in a stacking direction, a side, facing the second groove part 402, of a semiconductor functional layer 210 adjacent to the second groove part 402 has an avoidance recess. It can be understood that, for an implementation of the avoidance recess in this embodiment, reference may be made to the implementation of the avoidance recess in the foregoing embodiments. Details are not described herein again.

In some embodiments of this application, as shown in FIG. 27 to FIG. 28c, a shape of the avoidance recess is the same as a shape at a corresponding position on the second groove part 402.

In some embodiments of this application, a proportion of the first groove part 401 in the groove region 400, a proportion of the second groove part 402 in the groove region 400, a percentage of a coverage area of the electrode metal layer 230 in a total area of the entire photoelectric device, a proportion of an area of a first electrode metal layer 230 part in a total area of the electrode metal layer 230, and a proportion of an area of a second electrode metal layer 230 part in the total area of the electrode metal layer 230 may also meet a numerical relationship in the foregoing embodiments. Details are not described herein again.

In some embodiments of this application, as shown in FIG. 27, the groove region 400 is of a grid pattern, and the second groove part 402 is arranged in at least a part of grid cross regions in the grid pattern, or the second groove part 402 is arranged on at least a part of grid lines in the grid pattern. It can be understood that, for an implementation of the grid pattern 420 in this embodiment, reference may be made to the implementation of the grid pattern 420 in the foregoing embodiments. Details are not described herein again.

In some embodiments of this application, there is an included angle between a side wall of the semiconductor functional layer 210 and a first surface S1, the included angle faces a side of the semiconductor functional layer 210, and the included angle is an obtuse angle or a right angle. It can be understood that, for an implementation of the included angle in this embodiment, reference may be made to the implementation of the included angle in the foregoing embodiments. Details are not described herein again.

In some embodiments of this application, as shown in FIG. 28a to FIG. 28c, the electrode metal layer 230 covers a part or all of side walls of the semiconductor functional layer 210.

In some embodiments of this application, as shown in FIG. 28a to FIG. 28c, the electrode metal layer 230 extends to cover the first surface S1 and forms a second contact hole 332 on the first surface S1 in an enclosed manner, and the second dielectric layer 321 extends to cover the first surface S1 and forms a third contact hole 333 on an inner side of the second contact hole 332 in an enclosed manner. In addition, the first electrode 220 is electrically connected to the second semiconductor layer 213 through the second contact hole 332 and the third contact hole 333, and the first electrode 220 is insulated from the electrode metal layer 230. It can be understood that, for implementations of the second contact hole 332 and the third contact hole 333 in this embodiment, reference may be made to the implementations of the second contact hole 332 and the third contact hole 333 in the foregoing embodiments. Details are not described herein again.

In some embodiments of this application, as shown in FIG. 28a to FIG. 28c, a part, extending from the side wall of the semiconductor functional layer 210 to the first surface S1, of the electrode metal layer 230 is in a double-step shape. It can be understood that, for an implementation of the double-step shape in this embodiment, reference may be made to the implementation of the double-step shape in the foregoing embodiments. Details are not described herein again.

In some embodiments of this application, as shown in FIG. 28a to FIG. 28c, the semiconductor functional layer 210 further includes a current extension layer 214. The current extension layer 214 is disposed on the second semiconductor layer 213. A surface, facing away from the light-emitting layer, of the second semiconductor layer has a first region and a second region. The first region surrounds the second region. The current extension layer 214 covers the second region. The second dielectric layer 321 further covers the first region. The electrode metal layer 230 further covers a second dielectric layer 321 located in the first region. It can be understood that, for this implementation, reference may be made to the implementations in the foregoing embodiments. Details are not described herein again.

In some embodiments of this application, as shown in FIG. 28a to FIG. 28c, the first electrode 220 includes a first electrode connection layer 221 and a first electrode pad layer 222 that are connected to each other. The first electrode connection layer 221 is disposed between the first electrode pad layer 222 and the semiconductor functional layer 210. The first electrode connection layer 221 is connected to the second semiconductor layer 213 through the second contact hole 332 and the third contact hole 333. It can be understood that, for implementations of the first electrode connection layer 221 and the first electrode pad layer 222 in this embodiment, reference may be made to the implementations of the first electrode connection layer 221 and the first electrode pad layer 222 in the foregoing embodiments. Details are not described herein again.

In some embodiments of this application, in a stacking direction of the light-emitting layer and the second semiconductor layer, a spacing between an outer boundary of the first electrode connection layer and an outer boundary of the second contact hole is greater than 0. In the stacking direction of the light-emitting layer and the second semiconductor layer, the first electrode connection layer covers the second contact hole; or in the stacking direction of the light-emitting layer and the second semiconductor layer, the first electrode connection layer is disposed in the second contact hole. It can be understood that, for implementations of the outer boundary of the first electrode connection layer and the outer boundary of the second contact hole, reference may be made to the implementations of the outer boundary of the first electrode connection layer and the outer boundary of the second contact hole in the foregoing embodiments. Details are not described herein again.

In some embodiments of this application, as shown in FIG. 28a to FIG. 28c, the first electrode pad layer 222 covers the second contact hole 332, and a passivation layer is disposed between the first electrode pad layer 222 and the electrode metal layer 230. It can be understood that, for an implementation of the first electrode pad layer 222 in this embodiment, reference may be made to the implementation of the first electrode pad layer 222 in the foregoing embodiments. Details are not described herein again.

In some embodiments of this application, as shown in FIG. 28a to FIG. 28c, a profile of the first electrode connection layer 221 in the stacking direction F0 has a first groove AX1, the first groove AX1 is filled with a partial region of the first electrode pad layer 222, and the stacking direction F0 is perpendicular to a plane on which a substrate 100 is located. It can be understood that, for an implementation of the first groove AX1 in this embodiment, reference may be made to the implementation of the first groove AX1 in the foregoing embodiments. Details are not described herein again.

In some embodiments of this application, the light-emitting pixel further includes a distributed Bragg reflection layer 812, and the distributed Bragg reflection layer 812 is disposed between the electrode metal layer 230 and the second dielectric layer 321. It can be understood that, for an implementation of the distributed Bragg reflection layer 812 in this embodiment, reference may be made to the implementation of the distributed Bragg reflection layer 812 in the foregoing embodiments. Details are not described herein again.

In some embodiments of this application, the distributed Bragg reflection layer 812 covers the first dielectric layer 322, and the second groove part 402 and the third contact hole 333 are exposed from the distributed Bragg reflection layer 812.

In some embodiments of this application, as shown in FIG. 27 and FIG. 28a, the photoelectric device further includes one or more boss structures 510 and a second electrode 520. The boss structure 510 and the light-emitting pixel 200 are disposed at a spacing. The boss structure 510 has a second surface S2. The second electrode 520 is disposed on the second surface S2, and the second electrode 520 is connected to the electrode metal layer 230.

In some embodiments of this application, as shown in FIG. 27 and FIG. 28a, the second electrode 520 includes a second electrode connection layer 521 and a second electrode pad layer 522 that are connected to each other, and the second electrode connection layer 521 is disposed between the second electrode pad layer 522 and the boss structure 510. In addition, the second electrode connection layer 521 covers at least a partial region of the second surface S2, and the second electrode connection layer 521 further covers at least a partial side wall of the boss structure 510. It can be understood that, for implementations of the second electrode connection layer 521 and the second electrode pad layer 522 in this embodiment, reference may be made to the implementations of the second electrode connection layer 521 and the second electrode pad layer 522 in the foregoing embodiments. Details are not described herein again.

In some embodiments of this application, as shown in FIG. 27 and FIG. 28a, the second electrode connection layer 521 covers all side walls of the boss structure 510.

In some embodiments of this application, as shown in FIG. 27 and FIG. 28a, the second electrode connection layer 521 covers all regions of the second surface S2.

In some embodiments of this application, as shown in FIG. 27 and FIG. 28a, a third dielectric layer 323 is disposed between the second electrode connection layer 521 and the boss structure 510. The third dielectric layer 323 covers a side wall of the boss structure 510. The third dielectric layer 323 further extends to the second surface S2, and forms a fourth contact hole 334 on the second surface S2 in an enclosed manner. The second electrode connection layer 521 is in contact with the second surface S2 through the fourth contact hole 334.

In some embodiments of this application, as shown in FIG. 27 and FIG. 28a, the second electrode pad layer 522 covers the fourth contact hole 334.

In some embodiments of this application, as shown in FIG. 28a, a profile of the second electrode connection layer 521 in the stacking direction F0 has a second groove AX2, and the second groove AX2 is filled with a partial region of the second electrode pad layer 522. It can be understood that, for an implementation of the second groove AX2 in this embodiment, reference may be made to the implementation of the second groove AX2 in the foregoing embodiments. Details are not described herein again.

In some embodiments of this application, as shown in FIG. 27 and FIG. 28a, a third dielectric layer 323 is disposed between the second electrode connection layer 521 and the boss structure 510, the third dielectric layer 323 covers a side wall of the boss structure 510, and the second dielectric layer 321 further covers the second surface S2. It can be understood that, for an implementation of the second dielectric layer 321 in this embodiment, reference may be made to the implementation of the second dielectric layer 321 in the foregoing embodiments. Details are not described herein again.

In some embodiments of this application, as shown in FIG. 27 and FIG. 28a, the first dielectric layer 322, the second dielectric layer 321, and the third dielectric layer are formed by using a same film layer.

In some embodiments of this application, as shown in FIG. 27 and FIG. 28a, the second electrode connection layer 521 and the electrode metal layer 230 are formed by using a same film layer. It can be understood that, for implementations of the second electrode connection layer 521 and the electrode metal layer 230 in this embodiment, reference may be made to the implementations of the second electrode connection layer 521 and the electrode metal layer 230 in the foregoing embodiments. Details are not described herein again.

In some embodiments of this application, the boss structure 510 is of a single-layer structure, and the boss structure 510 includes one of a semiconductor material layer, an insulation material layer, or a metal material layer. It can be understood that, for an implementation of the boss structure 510 in this embodiment, reference may be made to the implementation of the boss structure 510 in the foregoing embodiments. Details are not described herein again.

In some embodiments of this application, the boss structure 510 is of a multi-layer structure, and the boss structure 510 includes a combination of a semiconductor material layer, an insulation material layer, or a metal material layer. It can be understood that, for an implementation of the boss structure 510 in this embodiment, reference may be made to the implementation of the boss structure 510 in the foregoing embodiments. Details are not described herein again.

In some embodiments of this application, as shown in FIG. 28a, the boss structure 510 is of a multi-layer structure, and the boss structure includes a semiconductor functional layer, or the boss structure includes a semiconductor functional layer and a current extension layer 214 disposed on the semiconductor functional layer. It can be understood that, for an implementation of the boss structure 510 in this embodiment, reference may be made to the implementation of the boss structure 510 in the foregoing embodiments. Details are not described herein again.

In some embodiments of this application, as shown in FIG. 28a, the light-emitting pixel further includes a distributed Bragg reflection layer 812, and the distributed Bragg reflection layer 812 further extends to a region between the third dielectric layer 323 and the second electrode connection layer 521. It can be understood that, for an implementation of the distributed Bragg reflection layer 812 in this embodiment, reference may be made to the implementation of the distributed Bragg reflection layer 812 in the foregoing embodiments. Details are not described herein again.

In some embodiments of this application, a first vertical distance exists between the first surface S1 of the semiconductor functional layer 210 and the first semiconductor layer, a second vertical distance exists between the second surface S2 of the boss structure 510 and the first semiconductor layer, and a difference between the first vertical distance and the second vertical distance is less than or equal to a difference threshold. It can be understood that, for implementations of the first vertical distance and the second vertical distance in this embodiment, reference may be made to the implementations of the first vertical distance and the second vertical distance in the foregoing embodiments. Details are not described herein again.

Based on this, an embodiment of this application further provides a light-emitting module. As shown in FIG. 23 and FIG. 24, the light-emitting module includes a photoelectric device 10, a drive device 30, and an interconnection assembly 20. The drive device 30 is located on a side, with a plurality of light-emitting pixels, of the photoelectric device 10, and the drive device 30 includes a first drive pad 31. The interconnection assembly 20 is located between the photoelectric device 10 and the drive device 30, and the interconnection assembly 20 includes a first interconnection structure 21. In addition, a first end of the first interconnection structure 21 is connected to a first electrode 220, and a second end of the first interconnection structure 21 is connected to the first drive pad 31.

In some embodiments of this application, as shown in FIG. 25 to FIG. 26c, the photoelectric device 10 further includes a boss structure 510 and a second electrode 520 that are located on a substrate 100, the drive device 30 further includes a second drive pad 32, and the interconnection assembly 20 further includes a second interconnection structure 22. In addition, a first end of the second interconnection structure 22 is connected to the second electrode 520, and a second end of the second interconnection structure 22 is connected to the second drive pad 32.

It can be understood that, for a preparation method for the photoelectric device in this embodiment, reference may also be made to the preparation method in the foregoing embodiments. Details are not described herein again.

It should be noted that the implementations in Embodiment 3 may alternatively not rely on the implementations in Embodiment 1 or Embodiment 2, and may alternatively be other implementations. This is not specifically limited herein.

It should be noted that features in the foregoing different embodiments may be combined with each other if no conflict occurs. Details are not described herein. In addition, the foregoing content is merely specific implementations of this application, but is not intended to limit the protection scope of this application. Any variation or replacement readily figured out by a person skilled in the art within the technical scope disclosed in this application shall fall within the protection scope of this application.

## Claims

1. A photoelectric device, comprising:
a plurality of light-emitting pixels, wherein each light-emitting pixel comprises a semiconductor functional layer and a first electrode, each semiconductor functional layer comprises a first semiconductor layer, and the plurality of light-emitting pixels share a first semiconductor layer;
a groove region formed on the semiconductor functional layer, wherein the groove region is located between the plurality of light-emitting pixels, and the groove region comprises a first groove part and a second groove part; and
an electrode metal layer, configured to electrically connect to a second electrode, wherein
the electrode metal layer covers at least a partial surface of each light-emitting pixel, at least a partial region of the first groove part, and at least a partial region of the second groove part;
the electrode metal layer is insulated from the semiconductor functional layer in the first groove part; and
the electrode metal layer is electrically connected to the first semiconductor layer in the second groove part.

2. The photoelectric device according to claim 1, wherein a first dimension exists between side walls of a groove region having the second groove part, a second dimension exists between side walls of a groove region having the first groove part, and a maximum value of the first dimension is greater than a maximum value of the second dimension.

3. The photoelectric device according to claim 1 or 2, wherein the first groove part is located between adjacent light-emitting pixels, and the first groove part further surrounds the second groove part and is in communication with the second groove part.

4. The photoelectric device according to claim 3, wherein the groove region is of a grid pattern, and the second groove part is arranged in at least a part of grid cross regions in the grid pattern, or the second groove part is arranged on at least a part of grid lines in the grid pattern.

5. The photoelectric device according to any one of claims 1 to 4, wherein a proportion of the first groove part in the groove region is greater than or equal to 50%, and the proportion of the first groove part in the groove region is less than 100%; or
a proportion of the second groove part in the groove region is greater than 0, and the proportion of the second groove part in the groove region is less than or equal to 50%.

6. The photoelectric device according to any one of claims 1 to 5, wherein the electrode metal layer covers at least a partial region of a bottom wall of the first groove part, or the electrode metal layer covers at least a partial region of a bottom wall of the second groove part.

7. The photoelectric device according to any one of claims 1 to 6, wherein a part, extending from the first groove part to the second groove part, of the electrode metal layer forms a step shape.

8. The photoelectric device according to claim 7, wherein a first dielectric layer is disposed between the electrode metal layer and the bottom wall of the first groove part.

9. The photoelectric device according to any one of claims 1 to 8, wherein a region, corresponding to the light-emitting pixel, of the first semiconductor layer is protrudingly arranged, a first semiconductor layer between adjacent light-emitting pixels forms a bottom wall of the groove region, and a side wall of the protruding region of the first semiconductor layer forms at least a partial side wall of the groove region.

10. The photoelectric device according to claim 9, wherein the semiconductor functional layer further comprises a light-emitting layer and a second semiconductor layer, the light-emitting layer is disposed on the first semiconductor layer that is disposed in a protruding manner, the second semiconductor layer is disposed on the light-emitting layer, and the first electrode is electrically connected to the second semiconductor layer; and
the side wall of the protruding region of the first semiconductor layer, a side wall of the light-emitting layer, and a side wall of the second semiconductor layer form a side wall of the groove region.

11. The photoelectric device according to claim 10, wherein the electrode metal layer covers the side wall of the first semiconductor layer, the side wall of the light-emitting layer, and the side wall of the second semiconductor layer, and a second dielectric layer is disposed between the electrode metal layer and the side wall of the first semiconductor layer, the side wall of the light-emitting layer, and the side wall of the second semiconductor layer.

12. The photoelectric device according to claim 11, wherein the light-emitting pixel further comprises a current extension layer, the current extension layer is disposed on the second semiconductor layer, and the second dielectric layer further covers a side wall of the current extension layer; and
the electrode metal layer further covers a second dielectric layer located on the side wall of the current extension layer.

13. The photoelectric device according to claim 12, wherein a surface, facing away from the second semiconductor layer, of the current extension layer is a first surface, the electrode metal layer extends to cover the first surface and forms a second contact hole on the first surface in an enclosed manner, and the second dielectric layer extends to cover the first surface and forms a third contact hole on an inner side of the second contact hole in an enclosed manner; and
the first electrode is electrically connected to the second semiconductor layer through the second contact hole and the third contact hole, and the first electrode is insulated from the electrode metal layer.

14. The photoelectric device according to claim 13, wherein a part, extending from the side wall of the second semiconductor layer to the first surface, of the electrode metal layer forms a double-step shape.

15. The photoelectric device according to claim 14, wherein a surface, facing away from the light-emitting layer, of the second semiconductor layer has a first region and a second region, the first region surrounds the second region, and the current extension layer covers the second region; and
the second dielectric layer further covers the first region, and the electrode metal layer further covers a second dielectric layer located in the first region.

16. The photoelectric device according to any one of claims 1 to 15, wherein the first electrode comprises a first electrode connection layer and a first electrode pad layer that are connected to each other, the first electrode connection layer is disposed between the first electrode pad layer and the current extension layer, and the first electrode connection layer is connected to the current extension layer through the second contact hole and the third contact hole.

17. The photoelectric device according to claim 16, wherein in a stacking direction of the light-emitting layer and the second semiconductor layer, a spacing between an outer boundary of the first electrode connection layer and an outer boundary of the second contact hole is greater than 0; and
in the stacking direction of the light-emitting layer and the second semiconductor layer, the first electrode connection layer covers the second contact hole; or in the stacking direction of the light-emitting layer and the second semiconductor layer, the first electrode connection layer is disposed in the second contact hole.

18. The photoelectric device according to claim 17, wherein in the stacking direction of the light-emitting layer and the second semiconductor layer, the first electrode pad layer covers the second contact hole, and a passivation layer is disposed between the first electrode pad layer and the electrode metal layer.

19. The photoelectric device according to any one of claims 16 to 18, wherein a profile of the first electrode connection layer in the stacking direction of the light-emitting layer and the second semiconductor layer has a first groove, and the first groove is filled with a partial region of the first electrode pad layer.

20. The photoelectric device according to any one of claims 1 to 19, wherein the photoelectric device further comprises one or more boss structures, the boss structure has a second surface, and the second electrode is disposed on the second surface; and
the groove region is further arranged between the boss structure and the light-emitting pixel, or the groove region is further arranged between boss structures.

21. The photoelectric device according to claim 20, wherein the groove region is further arranged between adjacent boss structures and between the boss structure and the light-emitting pixel, and the electrode metal layer further covers a side wall of the boss structure.

22. The photoelectric device according to claim 21, wherein the second electrode comprises a second electrode connection layer and a second electrode pad layer that are connected to each other, and the second electrode connection layer is disposed between the second electrode pad layer and the boss structure; and
the second electrode connection layer covers at least a partial region of the second surface, and the electrode metal layer and the second electrode connection layer are connected to each other.

23. The photoelectric device according to claim 21, wherein a third dielectric layer is disposed between the second electrode connection layer and the boss structure, and the third dielectric layer covers the side wall of the boss structure; and
the third dielectric layer further extends to the second surface and forms a fourth contact hole on the second surface in an enclosed manner, and the second electrode connection layer covers the third dielectric layer and is in contact with the second surface through the fourth contact hole; or the third dielectric layer covers the second surface, and the second electrode connection layer covers the third dielectric layer.

24. The photoelectric device according to any one of claims 20 to 23, wherein the boss structure is of a single-layer structure, and the boss structure comprises one of a semiconductor material layer, an insulation material layer, or a metal material layer; or
the boss structure is of a multi-layer structure, and the boss structure comprises a combination of a semiconductor material layer, an insulation material layer, or a metal material layer.

25. The photoelectric device according to claim 24, wherein the boss structure is of the multi-layer structure; and
the boss structure comprises the semiconductor functional layer, or the boss structure comprises the semiconductor functional layer and a current extension layer disposed on the semiconductor functional layer.

26. The photoelectric device according to any one of claims 11 to 25, wherein the light-emitting pixel further comprises a distributed Bragg reflection layer, and the distributed Bragg reflection layer is disposed between the electrode metal layer and the second dielectric layer.

27. A light-emitting module, comprising:
the photoelectric device according to any one of claims 1 to 26;
a drive device located on a side, with a plurality of light-emitting pixels, of the photoelectric device, wherein the drive device comprises a first drive pad and a second drive pad; and
an interconnection assembly located between the photoelectric device and the drive device, wherein the interconnection assembly comprises a first interconnection structure and a second interconnection structure, a first end of the first interconnection structure is connected to the first electrode, a second end of the first interconnection structure is connected to the first drive pad, a first end of the second interconnection structure is connected to the second electrode, and a second end of the second interconnection structure is connected to the second drive pad.

28. An electronic device, comprising a circuit board and the light-emitting module according to claim 27, wherein the circuit board is connected to a drive device in the light-emitting module.
